# EUROPEAN PATENT APPLICATION

(11) **EP 4 835 172 A1**
(43) Date of publication of application: **04.11.2026**
(21) Application number: 24962412.3
(22) Date of filing: 04.12.2024
(51) Int. Cl.: C30B 23/00, C30B 29/36

(54) **CRYSTAL GROWTH METHOD, AND METHOD FOR PREPARING CRYSTAL GROWTH STARTING MATERIAL**

(71) Applicant: BOYA ADVANCED MATERIALS CO., LTD., Meishan, Sichuan 620010 (CN)
(72) Inventor: WANG, Yu, Meishan, Sichuan 620010 (CN); FU, Jun, Meishan, Sichuan 620010 (CN); GU, Peng, Meishan, Sichuan 620010 (CN); LEI, Pei, Chengdu, Sichuan 610200 (CN); YUAN, Li, Chengdu, Sichuan 610200 (CN)
(74) Representative: Wang, Bo
(86) International application number: PCT/CN2024/136690
(87) International publication number: WO 2026/117963

(57) **Abstract**

According to an aspect of the present disclosure, a method for crystal growth and a method for preparing raw material for crystal growth are provided. The method for crystal growth includes: placing a target seed crystal for growth and a target raw material for growth into a growth chamber; and controlling a growth process of a crystal based on a stage control parameter. The stage control parameter includes at least one of pressure, temperature, an inflow rate of inert gas, and an opening degree of a control valve. The method for preparing raw material for crystal growth includes: obtaining initial powder based on a first raw material and a second raw material; placing the initial powder into the growth chamber for synthesis to obtain initial raw material for growth; and performing at least one processing operation on the initial raw material for growth to obtain the target raw material for growth.

## Description

### TECHNICAL FIELD

The present disclosure generally relates to the field of crystal growth, and in particular to a method for crystal growth and a method for preparing raw material for crystal growth.

### BACKGROUND

Silicon carbide (SiC) crystals have excellent physicochemical properties and are currently widely used in the fields of electronic devices with high frequency, high power, and high breakdown voltage. At present, methods for growth of SiC crystals mainly include a physical vapor transport method (physical vapor transport (PVT) method), a chemical vapor deposition method (chemical vapor deposition (CVD) method), or the like. Among them, the PVT method is a method that has been developed to be relatively mature and is more suitable for industrial mass production. In an existing PVT method, after loading a material into a crucible, operations such as crystal growth preparation, crystal growth initiation, crystal growth, and crystal growth termination can be completed in sequence, and a crystal that has completed growth can be obtained. However, the existing PVT method has problems such as a slow crystal growth rate and low quality of prepared crystals.

Therefore, it is desired to provide a method for crystal growth and a method for preparing raw material for crystal growth, which enable a crystal to grow rapidly while ensuring crystal growth quality.

### SUMMARY

One or more embodiments of the present disclosure provide a method for crystal growth, the method comprising: placing a target seed crystal for growth and a target raw material for growth into a growth chamber; controlling a growth process of a crystal based on a stage control parameter, wherein the stage control parameter comprises at least one of pressure, temperature, an inflow rate of an inert gas, or an opening degree of a control valve.

One or more embodiments of the present disclosure also provide a method for preparing raw material for crystal growth, the method comprising: obtaining an initial powder based on a first raw material and a second raw material; placing the initial powder into a growth chamber for synthesis to obtain an initial raw material for growth; performing at least one processing operation on the initial raw material for growth to obtain a target raw material for growth.

### BRIEF DESCRIPTION OF THE DRAWINGS

The present disclosure is further described in terms of exemplary embodiments, which are described in detail by means of the accompanying drawings. These embodiments are not limiting, and in these embodiments, like reference numerals denote like structures, wherein:
FIG. 1 is a structural schematic diagram illustrating an exemplary crystal growth apparatus according to some embodiments of the present disclosure;
FIG. 2 is a flowchart illustrating an exemplary method for crystal growth according to some embodiments of the present disclosure;
FIG. 3 is a schematic diagram illustrating an exemplary process curve of the method for crystal growth according to some embodiments of the present disclosure;
FIG. 4 is a schematic diagram illustrating an exemplary process curve of a first type of control stage according to some embodiments of the present disclosure;
FIG. 5 is a schematic diagram illustrating an exemplary process curve of a second type of control stage according to some embodiments of the present disclosure;
FIG. 6 is a schematic diagram illustrating an exemplary process curve of a third type of control stage according to some embodiments of the present disclosure;
FIG. 7 is a schematic diagram illustrating an exemplary process curve of a fourth type of control stage according to some embodiments of the present disclosure;
FIG. 8 is a schematic diagram illustrating an exemplary process curve of a fifth type of control stage according to some embodiments of the present disclosure;
FIG. 9 is a flowchart illustrating an exemplary method for preparing the target seed crystal for growth according to some embodiments of the present disclosure;
FIG. 10 is a flowchart illustrating an exemplary method for preparing a raw material for crystal growth according to some embodiments of the present disclosure;
FIG. 11 is a structural diagram illustrating an exemplary apparatus for preparing a second coating layer according to some embodiments of the present disclosure;
FIG. 12 is a schematic diagram illustrating an exemplary process curve for preparing the second coating layer according to some embodiments of the present disclosure; and
FIG. 13 is a schematic diagram illustrating an exemplary temperature of the growth control stage according to some embodiments of the present disclosure.

### DETAILED DESCRIPTION

In order to more clearly describe the technical solutions of the embodiments of the present disclosure, the drawings to be used in the following description of the embodiments are briefly introduced. Evidently, the drawings in the following description are merely some examples or embodiments of the present disclosure, and for those skilled in the art, the present disclosure may also be applied to other similar scenarios based on the drawings without making inventive efforts. Unless explicitly apparent from the context or otherwise stated, the same reference signs in the drawings represent the same structures or operations.

As shown in the present disclosure and the claims, unless the context clearly indicates otherwise, words such as 'a', 'an', and/or 'the' are not restricted to the singular, but may also include the plural. Generally, the terms 'comprises' and 'includes' are merely indicative of the inclusion of explicitly identified steps and elements, and do not constitute an exclusive enumeration, and a manner or an apparatus may also include other steps or elements.

In the present disclosure, flowcharts are used to illustrate operations performed by a system according to embodiments of the present disclosure. It should be understood that preceding or following operations are not necessarily performed in the exact order. Instead, the various steps may be performed in a reverse order or simultaneously. Meanwhile, other operations may be added to these processes, or one or more steps may be removed from these processes.

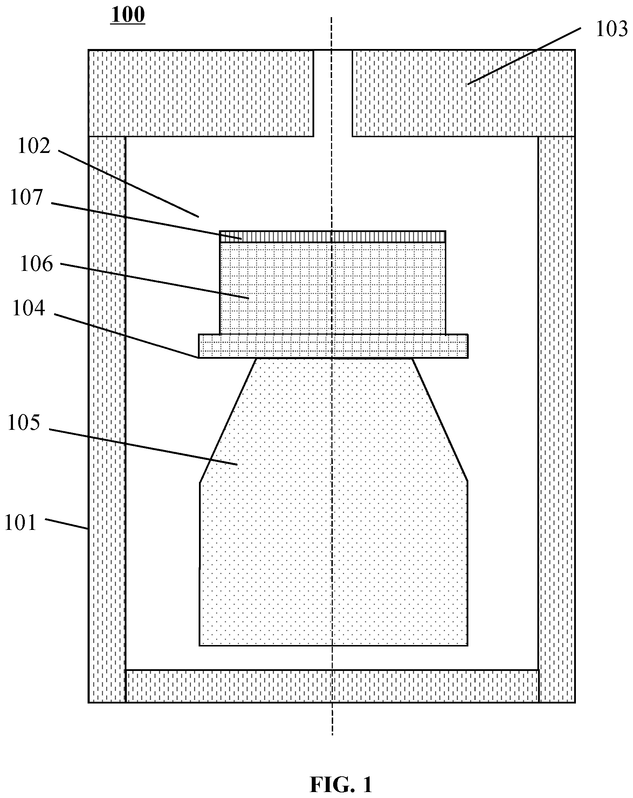

FIG. 1 is a schematic structural diagram illustrating a crystal growth apparatus according to some embodiments of the present disclosure.

The crystal growth apparatus 100 may be an apparatus for crystal growth. The crystal growth apparatus 100 may include, but is not limited to, a PVT crystal growth apparatus, a Liquid Phase Epitaxy (LPE) crystal growth apparatus, a Czochralski crystal growth apparatus, or the like.

Merely by way of example, the crystal growth apparatus 100 may be a silicon carbide crystal growth furnace. As shown in FIG. 1, the crystal growth apparatus 100 may include a furnace body 101, a crucible 102, a thermal insulation material 103, and a heating coil (not shown in FIG. 1). The furnace body 101 may accommodate other structures of the crystal growth apparatus 100. The heating coil may be configured to control a temperature inside the furnace body 101. The crucible 102 is disposed inside the furnace body 101.

In some embodiments, the crucible 102 may be partitioned by a gasket 104 into a raw material chamber 105 and a growth chamber 106. The raw material chamber 105 may be configured to accommodate a silicon carbide powder, and the growth chamber 106 may be configured to grow a silicon carbide crystal. In some embodiments, the growth chamber 106 may include a crystal growth position 107 (e.g., a position where a seed crystal is disposed, i.e., the seed crystal holder). The thermal insulation material may be configured to maintain or adjust the temperature inside the furnace body 101, thereby affecting crystal growth of the silicon carbide crystal inside the crystal growth apparatus 100.

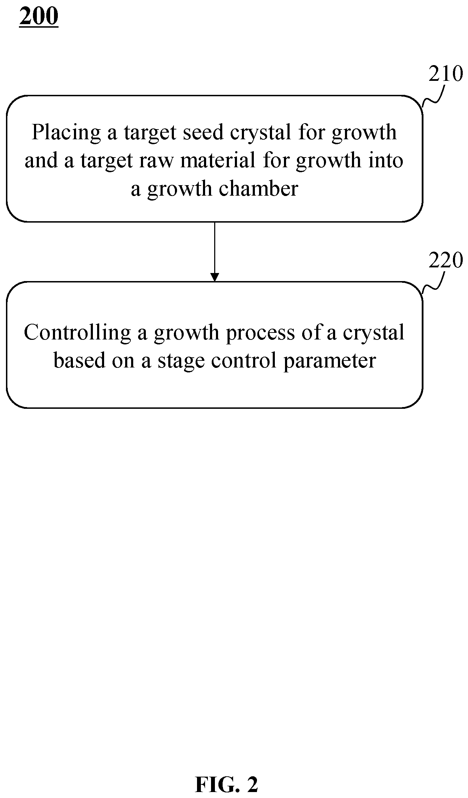

FIG. 2 is a flowchart illustrating an exemplary process for crystal growth according to some embodiments of the present disclosure. As shown in FIG. 2, a process 200 includes the following steps.

In 210, a target seed crystal for growth and a target raw material for growth are placed into a growth chamber.

The target seed crystal for growth refers to a seed crystal configured to grow a target crystal. The seed crystal refers to a small crystal having the same crystal orientation as a desired crystal (i.e., the target crystal), and is a seed for growing a single crystal, also referred to as a crystal seed. When using seed crystals with different crystal orientations as crystal seeds, single crystals with different crystal orientations will be obtained.

The growth chamber refers to a space where the crystal growth process takes place. In some embodiments, the growth chamber may be a vacuum chamber. As shown in FIG. 1, an inner space of the crucible 102 is the growth chamber, and the growth chamber may include the raw material chamber 105 and the growth chamber 106. More descriptions regarding the raw material chamber 105 and the growth chamber 106 may be found elsewhere in the present disclosure (e.g., FIG. 1 and related descriptions thereof).

In some embodiments, an initial seed crystal for growth that meets growth requirements may be selected from a plurality of initial seed crystals for growth as the target seed crystal for growth. For example, the growth requirements may include that a crystal orientation of a seed crystal is the same as a crystal orientation of a target crystal, and/or that a thickness of the seed crystal meets a thickness requirement.

In some embodiments, a SiC seed crystal having a crystal orientation of a 4° offset and a crystal form of 4H may be selected as the target seed crystal for growth.

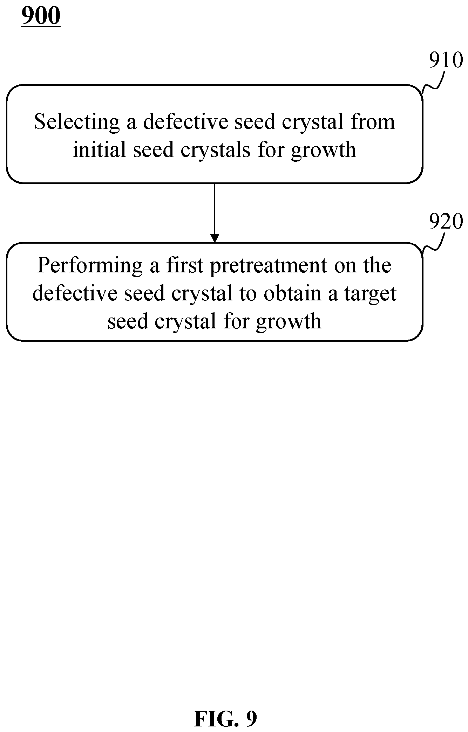

In some embodiments, for the initial seed crystal for growth that does not meet the growth requirements, a pretreatment may be performed to obtain the target seed crystal for growth that meets the growth requirements. More descriptions regarding obtaining the target seed crystal for growth may be found elsewhere in the present disclosure (e.g., FIG. 9 and related descriptions thereof).

Since a surface of the seed crystal is extremely prone to adhering to impurities such as dust and fine particulate matter, the obtained target seed crystal for growth needs to be strictly cleaned before crystal growth. In some embodiments, the target seed crystal for growth may be cleaned by an ultrasonic cleaning apparatus. The cleaned target seed crystal for growth may be dried by a sealed and clean oven. After the target seed crystal for growth is completely dried and cooled to room temperature, it may be taken out and placed in a clean, dry, and sealed container for standby use.

In some embodiments, the seed crystal holder may be made of graphite. Since graphite generally has a porous structure and limited processing precision. If a silicon surface of the target seed crystal for growth is directly fixed to a graphite seed crystal holder by bonding, the bonding between the seed crystal and the seed crystal holder (e.g., a graphite upper cover) may not be tight, and an adhesive used may contain a certain amount of moisture. During a crystal growth heating process, if the adhesive pyrolyzes too quickly and local boiling occurs, it may prevent the local adhesive from effectively bonding the seed crystal and the seed crystal holder. That is, a curing and carbonization process of the adhesive at a high temperature may easily result in local voids on a contact surface between the seed crystal and the seed crystal holder. The voids may lead to a temperature difference between the seed crystal and the seed crystal holder during the crystal growth process, and the temperature difference may cause a decomposition and sublimation phenomenon on a back surface of the seed crystal, thereby causing defects such as thermal decomposition cavities and hexagonal voids to appear, and even inducing generation of micropipe defects. The seed crystal holder refers to an apparatus in the growth chamber configured to fix a seed crystal. For example, the seed crystal holder may fix a seed crystal in the growth chamber by clamping, bonding, or the like. More descriptions regarding the seed crystal holder may be found in the following related descriptions.

In order to avoid the sublimation phenomenon on a back surface of the target seed crystal for growth during the crystal growth process, in some embodiments, before bonding the target seed crystal for growth to the seed crystal holder, a first coating layer may be set on the back surface of the target seed crystal for growth.

The first coating layer refers to a covering material set on the back surface of the target seed crystal for growth. The back surface of the target seed crystal for growth refers to another surface opposite to a surface where the target seed crystal for growth needs to grow a crystal. In some embodiments, the back surface of the target seed crystal for growth may be the silicon surface of the target seed crystal for growth.

In some embodiments, a material type of the first coating layer may include carbides such as hafnium carbide, yttrium carbide, tungsten carbide, or tantalum carbide, or the like. In some embodiments, the material type of the first coating layer may include nitrides such as tungsten nitride, tantalum nitride, or titanium nitride, or the like. In some embodiments, the material type of the first coating layer may also include borides such as tungsten boride, tantalum boride, or titanium boride, or the like.

In some embodiments, when the first coating layer is a dense metal compound film layer, a thickness range of the first coating layer may be from 0.1 µm to 20 µm. Preferably, the thickness range of the first coating layer may be from 2 µm to 5 µm.

In some embodiments, the first coating layer may be a dense metal compound film layer. When the first coating layer is a metal compound film layer of a different type, the thickness range of the first coating layer may be different.

In some embodiments, the back surface of the target seed crystal for growth may be coated with a first coating layer, and then the target seed crystal for growth coated with the first coating layer may be bonded to a seed crystal holder. More descriptions regarding the seed crystal holder may be found in the following related descriptions.

In some embodiments, when the first coating layer is a metal compound film layer of a different type, the first coating layer may be coated on the back surface of the target seed crystal for growth by a spray gun.

In some embodiments, when the first coating layer is a non-metal compound of a different type, a manner of coating the first coating layer on the back surface of the seed crystal may be different. In some embodiments, when the material type of the first coating layer is a carbide, the first coating layer may be coated on the back surface of the seed crystal by a CVD method, a spraying method, a magnetron sputtering method, an electron beam evaporation method, or the like. For example, hafnium carbide or yttrium carbide may be directly deposited or epitaxially grown on the back surface of the target seed crystal for growth by methods such as thermal evaporation, Physical Vapor Deposition (PVD), CVD, reactive sintering, plasma coating, liquid phase epitaxy, or laser deposition, or the like. In some embodiments, when the material type of the first coating layer is a nitride, the first coating layer may be coated on the back surface of the seed crystal by a CVD method, magnetron sputtering, arc ion plating, electron beam evaporation, or the like. In some embodiments, when the material type of the first coating layer is a boride, the first coating layer may be coated on the back surface of the seed crystal by a CVD method, a thermal spraying in-situ reaction synthesis method, or the like.

In embodiments of the present disclosure, setting a first coating layer on the back surface of the target seed crystal for growth may prevent sublimation from occurring on the back surface of the target seed crystal for growth during the crystal growth process. Since a melting point of the material corresponding to the first coating layer is higher than a growth temperature of the crystal, and the material corresponding to the first coating layer has high-temperature chemical stability and good thermal conductivity, the first coating layer may still exist on the back surface of the seed crystal in a solid state during the crystal growth process, thereby protecting the back surface of the seed crystal and inhibiting the generation of defects such as thermal decomposition pits and hexagonal voids caused by decomposition and sublimation of the back surface of the seed crystal.

In some embodiments, the material type of the first coating layer may also be a photoresist film layer. In some embodiments, before bonding the target seed crystal for growth to the seed crystal holder, a film may be coated on the back surface of the target seed crystal for growth to form a first coating layer, thereby preventing sublimation of the back surface of the target seed crystal for growth.

The coating manner includes photoresist coating. The photoresist coating refers to dripping a photoresist on a silicon surface of the seed crystal, uniformly coating it with a spin coater, then placing it in an oven for curing treatment, and repeating the process of coating and curing to obtain a seed crystal with a film layer of a certain thickness. Finally, the seed crystal coated with the photoresist film layer is placed in a vacuum furnace for carbonization treatment to form a dense carbon layer.

In some embodiments, when the material type of the first coating layer is a photoresist film layer, the thickness range of the first coating layer may be from 1 µm to 30 µm. Preferably, the thickness range of the first coating layer may be from 3 µm to 8 µm, thereby avoiding delamination caused by excessive thickness of the first coating layer.

In some embodiments, a robotic arm may be used to bond the filmed target seed crystal for growth with graphite paper, and the target seed crystal for growth bonded with the graphite paper may be placed in a hot pressing furnace for hot pressing, using different temperatures and pressures to bond the target seed crystal for growth and the graphite paper tightly, thereby preventing the target seed crystal for growth from being ablated during the crystal growth process. For example, a robotic arm may be used to apply B adhesive on the graphite paper, place the carbonized target seed crystal for growth on the graphite paper, and press down with a roller to firmly bond the target seed crystal for growth and the graphite paper.

The foregoing descriptions regarding processing the target seed crystal for growth are merely for illustrative purposes and are not intended to limit the scope of the present disclosure.

In some embodiments, the target seed crystal for growth bonded with the graphite paper may be bonded to a graphite upper cover, wherein the graphite upper cover is threadedly connected to the graphite crucible and achieves a sealed effect, so that the graphite upper cover and the graphite crucible form the growth chamber.

The target raw material for growth refers to an original material configured to prepare a desired crystal. In some embodiments, the target raw material for growth includes a powdered raw material. For example, a dendritic silicon carbide raw material, or the like.

When a powdered raw material is used for crystal growth, a chemical composition of the powdered raw material changes drastically during a heating and sublimation process, and it is extremely prone to generating a large number of fine carbon particles that are easy to fly, which directly restricts an improvement in crystal quality. In order to reduce changes in the chemical composition of the silicon carbide raw material during the heating and sublimation process and eliminate the fine carbon particles that are easy to fly, thereby improving the crystal growth quality, some embodiments of the present disclosure may use a bulk raw material as the target raw material for growth.

In some embodiments, the target raw material for growth may also be a bulk raw material, wherein a particle size of the bulk raw material may be from 1 mm to 100 mm, a bulk density of the bulk raw material may be from 1.8 g/cm² to 2.2 g/cm², a Mohs hardness of the bulk raw material may be from 9.0 to 9.5, and a crystal form of the bulk raw material may include 4H and 6H. In some embodiments, a surface of the bulk raw material is bright, dense, and free of porosity.

In some embodiments, the bulk raw material may be placed in the crucible in a laying flat manner. Since the particle size of the bulk raw material is relatively large, gaps between the bulk raw materials may be relatively large during a process of filling into the crucible. Therefore, small-sized bulk raw materials may be sprinkled into the gaps during the filling process to increase a filling density of the bulk raw material.

In embodiments of the present disclosure, selecting the bulk raw material facilitates controlling a carbon-to-silicon ratio in gas phase components during the crystal growth process, thereby making gas phase transport more stable. This is because an evaporation area of the bulk raw material may be smaller than an evaporation area of a powdered raw material (e.g., a dendritic material). Relatively, an evaporation rate of the bulk raw material may become slower, which is more conducive to controlling the carbon-to-silicon ratio in the gas phase components during the crystal growth process. During the evaporation process, the bulk raw material will not undergo excessive volume change due to carbonization, which would cause changes in heat transfer. Therefore, gas phase transport of the bulk raw material is more stable. At the same time, the bulk density of the bulk raw material is higher, allowing the same volume of raw material to sustain crystal growth for a longer time. Using the bulk raw material for crystal growth may yield crystals with greater thickness, and the crystal growth thickness may reach from 40 mm to 50 mm.

In addition, using the bulk raw material may also solve a carbon inclusion problem. The carbon inclusion problem refers to the seed crystal bringing some carbon from a graphite component into the seed crystal during the growth process, thereby forming a certain carbon inclusion on a surface of the crystal. The dendritic raw material is dendritic, and during a furnace loading process, the crucible may collide with the dendritic raw material, causing the dendritic raw material to become fragments or powder. After high temperature, gas phase transport may bring some small dendritic fragments or powder of the dendritic raw material into the crystal, thereby causing carbon inclusion. However, the bulk raw material has a higher density compared to a powdered raw material (e.g., a dendritic material), and is in a bulk form without branches. Moreover, the surface of the bulk raw material is uniform and smooth, and even if it evaporates during the volatilization process, no fine powder will appear, so the carbon inclusion problem can be solved.

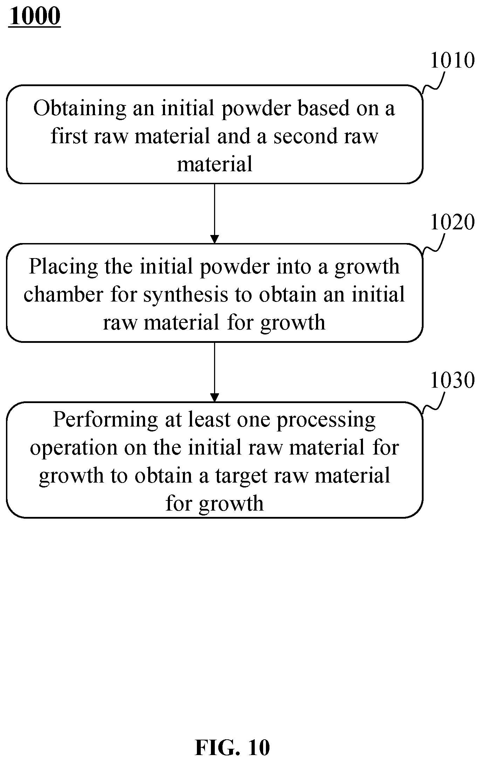

In some embodiments, a method for preparing the bulk raw material includes: obtaining an initial powder based on a first raw material and a second raw material; placing the initial powder into the growth chamber for synthesis to obtain an initial raw material for growth; and performing at least one processing operation on the initial raw material for growth to obtain the target raw material for growth. More descriptions regarding how to obtain the target raw material for growth may be found elsewhere in the present disclosure (e.g., FIG. 10 and related descriptions thereof).

In some embodiments, when placing the target seed crystal for growth into the growth chamber, the target seed crystal for growth may be bonded on a seed crystal holder.

The seed crystal holder is a device in the growth chamber configured to fix a seed crystal. In some embodiments, the seed crystal holder may include a clamping-type seed crystal holder and a bonding-type seed crystal holder. In some embodiments, the back surface of the target seed crystal for growth may be bonded on the seed crystal holder.

In some embodiments, before placing the target seed crystal for growth and the target raw material for growth into the growth chamber, a second pretreatment may be performed on the seed crystal holder. For example, the seed crystal holder may be placed into corresponding growth equipment, and the corresponding growth equipment may be configured to perform the second pretreatment on the seed crystal holder.

The second pretreatment refers to a processing operation for setting a coating layer on the seed crystal holder.

In some embodiments, the seed crystal holder is an annular structure, and the second pretreatment includes preparing a second coating layer on an inner ring surface of the seed crystal holder. The seed crystal holder may be a graphite material.

The second coating layer is a covering material set on the seed crystal holder. A rise in temperature during the crystal growth process may cause carbon from the seed crystal holder to be brought into the target seed crystal for growth along with the target raw material for growth, thereby forming a certain carbon inclusion. By setting the second coating layer on the seed crystal holder, which is equivalent to enveloping the seed crystal holder, carbon may also be prevented from being brought into the target seed crystal for growth to form carbon inclusion even in a high-temperature environment. For example, the crystal growth temperature is generally above 2000 degrees Celsius, and the second coating layer can withstand a high temperature above 3000 degrees Celsius. That is, if the temperature during the crystal growth process cannot melt the second coating layer, then the carbon of the seed crystal holder will not be brought out.

In some embodiments, the second coating layer has a material hardness greater than Mohs hardness 9, a melting point not less than 3000°C, and excellent chemical stability and corrosion resistance. In some embodiments, the material hardness of the second coating layer is greater than Mohs hardness 9.5. In some embodiments, the material hardness of the second coating layer is greater than Mohs hardness 10. In some embodiments, the melting point of the second coating layer may be not less than at least one of 3100°C, 3200°C, 3300°C, 3400°C, 3500°C, or the like.

In the embodiments of the present disclosure, preparing the second coating layer on the inner ring surface of the seed crystal holder through the second pretreatment may further prevent carbon inclusion from forming.

In some embodiments, a material type of the second coating layer includes tantalum carbide, tungsten carbide, or titanium carbide, or the like. Taking tantalum carbide as the material type of the second coating layer as an example, tantalum carbide is a ceramic material, having physical properties such as high hardness, high melting point, and low adhesiveness, or the like. The hardness of tantalum carbide can reach 2100 HV, the melting point is 3880°C, and a tensile strength can reach more than 3000 MPa. In addition, tantalum carbide also has good anti-oxidation and corrosion resistance properties. Therefore, using tantalum carbide as the material of the second coating layer may isolate the seed crystal holder and the growth chamber, thereby preventing the material of the seed crystal holder from affecting the crystal growth process.

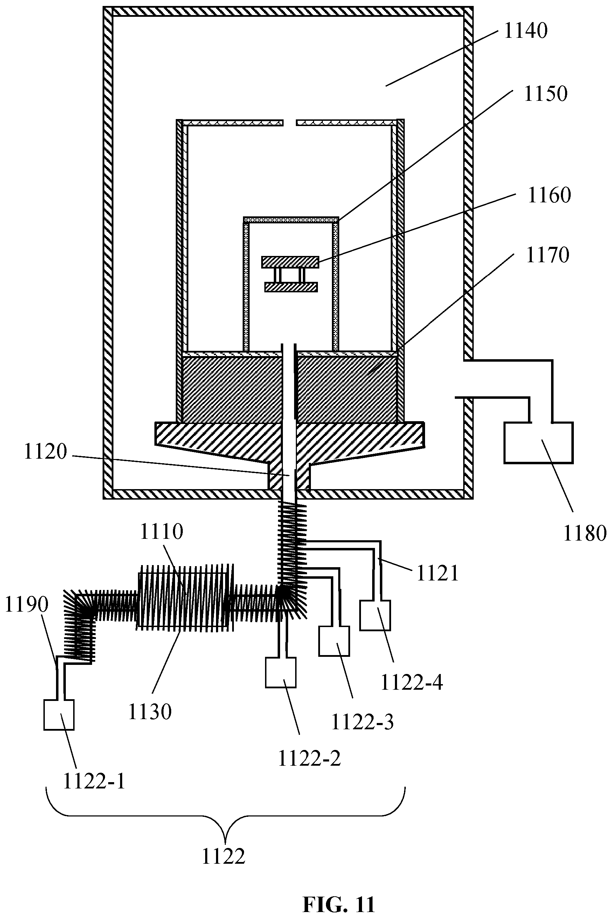

In some embodiments, as shown in FIG. 11, an apparatus for preparing the second coating layer may include an evaporator 1110, a gas pipeline 1120, a heater 1130, a vacuum chamber 1140, a graphite crucible 1150, and a seed crystal holder 1160.

The evaporator 1110 is configured to evaporate a coating raw material. The coating raw material may be a tantalum-containing compound, for example, a TaCl5 powder with a purity of 99.99%. The evaporator 1110 is connected to one end of the gas pipeline 1120. The evaporator 1110 is heated by the heater 1130 to evaporate the coating raw material, and then transmits the evaporated gas through the gas pipeline 1120 to the vacuum chamber 1140.

The gas pipeline 1120 is configured to transport a gas to the vacuum chamber 1140 for a chemical reaction to prepare the second coating layer on the inner ring surface of the seed crystal holder. One end of the gas pipeline 1120 is connected to the evaporator 1110, and the other end is in communication with the vacuum chamber 1140.

In some embodiments, the gas pipeline 1120 may include a plurality of pipe branches 1121, and different pipe branches 1121 are connected to different gas storage devices 1122.

The gas storage device 1122 is configured to store the gas required for preparing the second coating layer. For example, gas storage devices 1122-1 and 1122-2 are configured to store inert gas (e.g., argon gas with a purity of 99.999%, or the like). Gas storage device 1122-3 is configured to store hydrocarbon gas (e.g., C2H2, C2H4, C3H6, C3H8 with a purity of 99.999%, or the like). Gas storage device 1122-4 is configured to store reducing gas (e.g., hydrogen gas with a purity of 99.999%, or the like). Each gas storage device 1122 is configured to store a type of gas.

The heater 1130 is configured to heat the evaporator 1110, the gas pipeline 1120, and the vacuum chamber 1140. In some embodiments, the heater 1130 may be composed of resistance wires. For example, the evaporator 1110 and the gas pipeline 1120 may be heated by winding resistance wires thereon.

The graphite crucible 1150 may provide a heat source for the vacuum chamber 1140. The graphite crucible 1150 is disposed inside the vacuum chamber 1140.

In some embodiments, the apparatus for preparing the second coating layer may also include a heat preservation structure 1170. For example, the heat preservation structure 1170 may be graphite hard felt, or the like. During the deposition process, the heat preservation structure 1170 may serve to uniformize the temperature. In some embodiments, the heat preservation structure 1170 may be disposed at a bottom of the graphite crucible 1150. In some embodiments, the heat preservation structure 1170 may also be disposed on an outer periphery of the vacuum chamber 1140.

In some embodiments, the apparatus for preparing the second coating layer may also include a mechanical pump 1180. The mechanical pump 1180 is connected to the vacuum chamber 1140 and is configured to extract gas from the vacuum chamber 1140 after the coating preparation is completed.

In some embodiments, the apparatus for preparing the second coating layer may also include a plurality of flow controllers 1190. All the flow controllers 1190 are connected to the gas pipeline 1120, and each flow controller 1190 may be respectively connected to a gas storage device 1122. The flow controller 1190 may be configured to control an inflow of the process gas in the corresponding gas storage device 1122. The gas stored in one or more the gas storage devices 1122 may be transported to the vacuum chamber 1140 via the flow controller 1190 and the gas pipeline 1120 for a chemical reaction, wherein the gas transported by the gas pipeline 1120 includes gas evaporated from the coating raw material and one or more process gases.

In some embodiments, an apparatus for preparing the second coating layer may further include a guiding device (not shown in FIG. 11). The guiding device refers to a device configured to guide a direction of gas flow. The guiding device may be arranged inside the gas pipeline 1120, or may be arranged inside the vacuum chamber 1140.

In embodiments of the present disclosure, the apparatus with the above-mentioned structure is configured to prepare the second coating layer with higher crystallinity and density on the seed crystal holder of the annular structure. This preparation may effectively prevent an excess gas phase from freely depositing on the seed crystal holder, thereby affecting crystal quality, and simultaneously protect the seed crystal holder from being corroded under gas phase flushing, thereby preventing impurities from entering the crystal. By means of the guiding device, a gas precursor may be uniformly deposited on a surface of the seed crystal holder of the annular structure.

In some embodiments, the second coating layer may be prepared on an inner ring surface of the seed crystal holder using a CVD manner.

In some embodiments, a process flow for preparing the second coating layer on the inner ring surface of the seed crystal holder may include: filling an inert gas into the vacuum chamber until the pressure of the vacuum chamber reaches a first pressure range, and simultaneously performing the temperature increasing treatment to cause the temperature of the vacuum chamber to reach a first temperature range; using the heater to increase the temperature of the evaporator to a second temperature range, and performing the preheating treatment on the gas pipeline; and introducing a process gas, wherein the process gas deposits on the inner ring surface of the seed crystal holder to form the second coating layer.

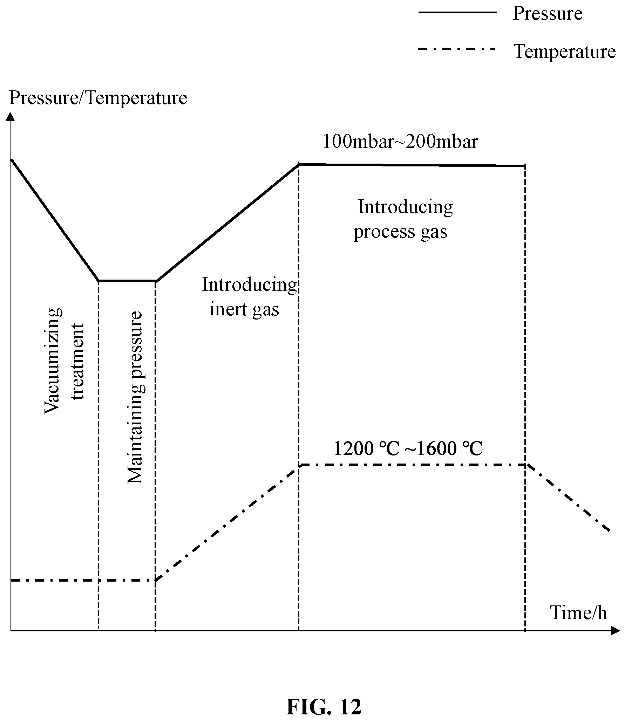

In some embodiments, as shown in FIG. 12, before filling an inert gas into the vacuum chamber, the vacuum chamber may first be subjected to a vacuumizing treatment. By means of the vacuumizing treatment, the pressure in the vacuum chamber may be caused to reach 10⁻⁵ Pa. The time duration for the vacuumizing treatment may be from 3 h to 5 h. After the vacuumizing is completed, it is necessary to check for leakage and maintain pressure for from 1 h to 2 h.

In some embodiments, as shown in FIG. 12, filling an inert gas into the vacuum chamber may cause the pressure of the vacuum chamber to reach from 100 mbar to 200 mbar. At the same time, by means of the temperature increasing treatment, the temperature of the vacuum chamber may be caused to reach from 1200°C to 1600°C.

In some embodiments, the inert gas filled into the vacuum chamber may include argon gas. The inert gas may be provided by the gas storage device connected to the flow controller. As shown in FIG. 11, gas storage devices 1122-1 and 1122-2 may provide argon gas with a purity of 99.999%.

In some embodiments, the first pressure range may be from 100 mbar to 200 mbar. In some embodiments, the first pressure range may further be one of 100 mbar to 180 mbar, 100 mbar to 160 mbar, 100 mbar to 140 mbar, 100 mbar to 120 mbar, 120 mbar to 200 mbar, 120 mbar to 180 mbar, 120 mbar to 160 mbar, 120 mbar to 140 mbar, 140 mbar to 200 mbar, 140 mbar to 180 mbar, 140 mbar to 160 mbar, 160 mbar to 200 mbar, 160 mbar to 180 mbar, or 180 mbar to 200 mbar. In some embodiments, the first pressure range may be one of 100 mbar, 110 mbar, 120 mbar, 130 mbar, 140 mbar, 150 mbar, 160 mbar, 170 mbar, 180 mbar, 190 mbar, or 200 mbar, or the like.

In some embodiments, by means of the graphite crucible, the vacuum chamber may be subjected to the temperature increasing treatment. In some embodiments, the first temperature range may be from 1200°C to 1600°C. In some embodiments, the first temperature range may further be one of 1200°C to 1550°C, 1200°C to 1500°C, 1200°C to 1450°C, 1200°C to 1400°C, 1200°C to 1350°C, 1200°C to 1300°C, 1250°C to 1550°C, 1250°C to 1500°C, 1250°C to 1450°C, 1250°C to 1400°C, 1250°C to 1350°C, 1300°C to 1600°C, 1300°C to 1550°C, 1300°C to 1500°C, 1300°C to 1450°C, 1300°C to 1400°C, 1350°C to 1600°C, 1350°C to 1550°C, 1350°C to 1500°C, 1350°C to 1450°C, 1400°C to 1600°C, 1400°C to 1550°C, 1400°C to 1500°C, 1450°C to 1600°C, 1450°C to 1550°C, or 1500°C to 1600°C, or the like. In some embodiments, the first temperature range may be one of 1200°C, 1250°C, 1300°C, 1350°C, 1400°C, 1450°C, 1500°C, or 1600°C, or the like.

In some embodiments, after the temperature of the vacuum chamber is stabilized, the heater may be used to heat the evaporator to the second temperature range and to subject the gas pipeline to the preheating treatment. For example, a resistance wire power supply may be connected for heating or the preheating treatment.

In some embodiments, the second temperature range may be from 180°C to 220°C. In some embodiments, the second temperature range may further be one of 190°C to 220°C, 200°C to 220°C, 210°C to 220°C, 180°C to 210°C, 190°C to 210°C, 200°C to 210°C, 180°C to 200°C, 190°C to 200°C, or 180°C to 190°C, or the like. In some embodiments, the second temperature range may be one of 180°C, 185°C, 190°C, 195°C, 200°C, 205°C, 210°C, 215°C, or 220°C, or the like.

In some embodiments, the preheating temperature of the gas pipeline may be from 200°C to 300°C. In some embodiments, the preheating temperature of the gas pipeline may further be one of 200°C to 280°C, 200°C to 260°C, 200°C to sublimation phenomenon °C, 220°C to 300°C, 220°C to 280°C, 220°C to 260°C, 220°C to 240°C, 240°C to 300°C, 240°C to 280°C, 240°C to 260°C, 260°C to 300°C, or 260°C to 280°C, or the like. In some embodiments, the preheating temperature of the gas pipeline may further be one of 200°C, 210°C, 220°C, 230°C, 240°C, 250°C, 260°C, 270°C, 280°C, 290°C, or 300°C, or the like.

In some embodiments, after the temperature of the evaporator reaches the second temperature range and the temperature of the gas pipeline reaches the preheating temperature of the gas pipeline, the process gas may be introduced into the vacuum chamber. The process gas may include a hydrocarbon gas and a reducing gas. As shown in FIG. 11, the gas storage device 1122-3 may provide hydrocarbon gas with a purity of 99.999%, and the gas storage device 1122-4 may provide hydrogen gas with a purity of 99.999%. In some embodiments, a compound may be produced from a plurality of process gases after performing a chemical reaction in the vacuum chamber. After the compound is deposited for a plurality of hours and cooled to room temperature, the seed crystal holder with the second coating layer plated thereon may be taken out. In some embodiments, a chemical expression for a chemical reaction performed in the vacuum chamber may be expressed as: 6TaCl₅+2C₃H₈+7H₂→6TaC+30HCl.

In some embodiments, after the evaporator is heated to the second temperature range, the coating raw material in the evaporator evaporates into a gas, and the evaporated coating raw material gas is transported to the vacuum chamber. Preheating the gas pipeline is to prevent a condensation condition from occurring during gas transportation. The gas storage device located at an inlet end of the evaporator (e.g., the gas storage device 1122-1 in FIG. 11) stores an inert gas. The inert gas may transport the evaporated coating raw material gas (a compound containing tantalum) to the vacuum chamber.

Since the coating raw material does not contain carbon element, the hydrocarbon gas in gas storage device 1122-3 may provide a carbon source. At the same time, since concentrations of the hydrogen gas in gas storage device 1122-4 and the hydrocarbon gas in gas storage device 1122-3 are relatively high, the argon gas in gas storage device 1122-2 may serve as a diluent gas, and may be transported to the vacuum chamber together with the hydrocarbon gas and the hydrogen gas. The argon gas may make the hydrocarbon gas and the hydrogen gas mixed more uniformly, thereby allowing deposition of the second coating layer to be more uniform. After the gas reaction in the vacuum chamber is completed, the gas may be extracted by means of the mechanical pump.

In embodiments of the present disclosure, by means of the above-mentioned manner, the uniform second coating layer may be prepared on the seed crystal holder of the annular structure to prevent formation of the carbon encapsulation.

In 220, the growth process of the crystal is controlled based on the stage control parameter.

The stage control parameter refers to a parameter for staged control of the crystal growth process. In some embodiments, the stage control parameter may include at least one of chamber pressure, chamber temperature, an inflow rate of inert gas, or an opening degree of the control valve. The control valve refers to a component configured to control whether to introduce gas into the vacuum chamber. By changing the opening degree of the control valve, a flow rate of introduced gas may be changed.

In some embodiments, the stage control parameter may include control parameters for a plurality of stages.

In some embodiments, the plurality of stages may comprise a preheating stage and a growth control stage.

The preheating stage refers to a stage configured to adjust an environment of the growth chamber before the growth process of a crystal. For example, the chamber temperature of the growth chamber may be adjusted during the preheating stage. In some embodiments, the chamber pressure of the growth chamber may also be adjusted during the preheating stage.

The growth control stage refers to a stage configured to adjust an environment of the growth chamber when the crystal is growing.

The chamber pressure and the chamber temperature of the growth chamber may both be adjusted during the preheating stage and the growth control stage. The values of the control parameters for different stages are different.

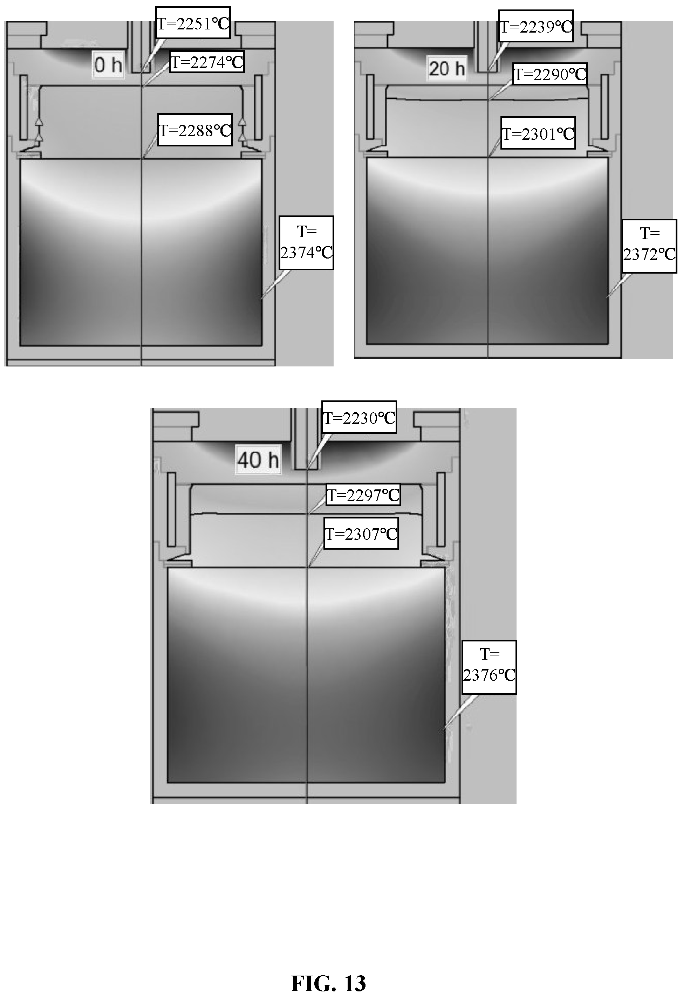

FIG. 13 is an exemplary schematic diagram illustrating the temperature of the growth control stage according to some embodiments of the present disclosure. FIG. 13 includes the upper cover temperature, the growth surface temperature, and a maximum temperature value within the raw material at 0 h, 20 h, and 40 h. The graphite upper cover is threadedly connected to the graphite crucible and achieves a sealing effect. The upper cover temperature refers to the temperature of the graphite upper cover connected to the graphite crucible. The growth surface temperature refers to the temperature of a growth surface of the crystal during growth. The temperature within the raw material refers to the temperature of the raw material cavity.

More descriptions regarding the preheating stage and the growth control stage may be found in the following related descriptions.

In some embodiments, the stage control parameter may be determined by human beings. In some embodiments, the stage control parameter may be determined based on historical data or prior knowledge.

The growth process of a crystal refers to a process in which a seed crystal and a raw material (e.g., the target seed crystal for growth and the target raw material for growth) undergo a chemical reaction under certain conditions, which is simply referred to as the growth process. After the growth process, the desired crystal may be obtained (e.g., a SiC crystal).

In some embodiments, the stage control parameter may comprise pressure parameters for the plurality of stages and/or temperature parameters.

The pressure parameter refers to pressure-related data in the growth chamber. In some embodiments, the pressure parameter may comprise a pressure change rate and/or a target pressure range. The pressure change rate refers to a pressure change amount per unit time, and the target pressure range refers to the adjusted pressure range.

The temperature parameter refers to temperature-related data in the growth chamber. In some embodiments, the temperature parameter may comprise a temperature change rate and/or a target temperature range. The temperature change rate refers to a temperature change amount per unit time, and the target temperature range refers to the adjusted temperature range.

During the crystal growth process, if crystal growth control is performed using high pressure or low pressure throughout the entire process, problems such as a quite limited growth rate, a low raw material utilization rate, a low crystal yield, and a high defect density will arise. In the embodiments of the present disclosure, by controlling the pressure and the temperature in the growth chamber in stages, crystals with better performance can be obtained.

In some embodiments, the stage control parameter includes the target pressure range of the preheating stage and the target temperature range of the preheating stage. The target pressure range of the preheating stage may be 500 mbar to 800 mbar, and the target temperature range of the preheating stage may be 1900 °C to 2000 °C.

In some embodiments, the target pressure range of the preheating stage may also be one of 500 mbar to 750 mbar, 500 mbar to 700 mbar, 500 mbar to 650 mbar, 500 mbar to 600 mbar, 550 mbar to 800 mbar, 550 mbar to 750 mbar, 550 mbar to 700 mbar, 550 mbar to 650 mbar, 600 mbar to 800 mbar, 600 mbar to 750 mbar, 600 mbar to 700 mbar, 650 mbar to 800 mbar, 650 mbar to 750 mbar, 700 mbar to 800 mbar, or the like. In some embodiments, the target pressure range of the preheating stage may be one of 500 mbar, 550 mbar, 600 mbar, 650 mbar, 700 mbar, 750 mbar, 800 mbar, or the like.

In some embodiments, the target temperature range of the preheating stage may also be one of 1900 °C to 1990 °C, 1900 °C to 1980 °C, 1900 °C to 1970 °C, 1900 °C to 1960 °C, 1900 °C to 1950 °C, 1910 °C to 2000 °C, 1910 °C to 1990 °C, 1910 °C to 1980 °C, 1910 °C to 1970 °C, 1910 °C to 1960 °C, 1910 °C to 1950 °C, 1920 °C to 2000 °C, 1920 °C to 1990 °C, 1920 °C to 1980 °C, 1920 °C to 1970 °C, 1920 °C to 1960 °C, 1920 °C to 1950 °C, 1930 °C to 2000 °C, 1930 °C to 1990 °C, 1930 °C to 1980 °C, 1930 °C to 1970 °C, 1930 °C to 1960 °C, 1930 °C to 1950 °C, 1940 °C to 2000 °C, 1940 °C to 1990 °C, 1940 °C to 1980 °C, 1940 °C to 1970 °C, 1940 °C to 1960 °C, 1940 °C to 1950 °C, 1950 °C to 2000 °C, 1950 °C to 1990 °C, 1950 °C to 1980 °C, 1950 °C to 1970 °C, 1950 °C to 1960 °C, or the like. In some embodiments, the target temperature range of the preheating stage may be one of 1900 °C, 1910 °C, 1920 °C, 1930 °C, 1940 °C, 1950 °C, 1960 °C, 1970 °C, 1980 °C, 1990 °C, 2000 °C, or the like.

In some embodiments, controlling the growth process of the crystal based on the stage control parameter during the preheating stage comprises: controlling an amount of gas introduced into the growth chamber so that the chamber pressure of the growth chamber reaches the target pressure range of the preheating stage; maintaining the chamber pressure within the target pressure range of the preheating stage, and performing a heating treatment so that a chamber temperature of the growth chamber reaches the target temperature range of the preheating stage before entering the growth control stage.

The chamber pressure refers to the real-time pressure in the growth chamber. The chamber pressure may be obtained by a pressure sensor disposed in the growth chamber. The gas introduced into the growth chamber is inert gas to increase the chamber pressure in the growth chamber. In some embodiments, the chamber pressure of the growth chamber may be regulated by controlling the amount of gas introduced into the growth chamber.

The chamber temperature refers to the real-time temperature in the growth chamber. The chamber temperature may be obtained by a temperature sensor disposed in the growth chamber. In some embodiments, the chamber temperature of the growth chamber may be regulated by controlling the power of the heating coil.

In some embodiments, the gas introduced into the growth chamber may comprise inert gas (e.g., helium or argon).

In some embodiments, during the preheating stage, the gas introduced into the growth chamber may comprise an alkyne compound. In some embodiments, the alkyne compound may comprise at least one of acetylene, phenylacetylene, or the like. For example, C₂H₂, C₂H₄, C₃H₆, C₃H₈, or the like with a purity of 99.999%. The temperature is slowly increased from 1900 °C to 2200 °C, and at the same time, C₂H₄ gas is slowly introduced into the growth chamber at a flow rate of 1 sccm/min to 5 sccm/min. The entire process lasts approximately 10 h, and the C₂H₄ gas supply is stopped after the temperature rises to 2200 °C.

Due to the vapor sublimated from a SiC source material, the early stage is seriously silicon-rich, thereby seriously affecting the overall quality of a crystal ingot. In the embodiments of the present disclosure, high-purity low-molecular-weight hydrocarbons are directly introduced into the growth chamber during an early stage of crystal growth (i.e., the preheating stage), thereby using the carbon generated by their cracking to correct the vapor carbon-to-silicon ratio and using the hydrogen generated by their cracking to adjust the crystal growth rate, further improving the crystal growth quality.

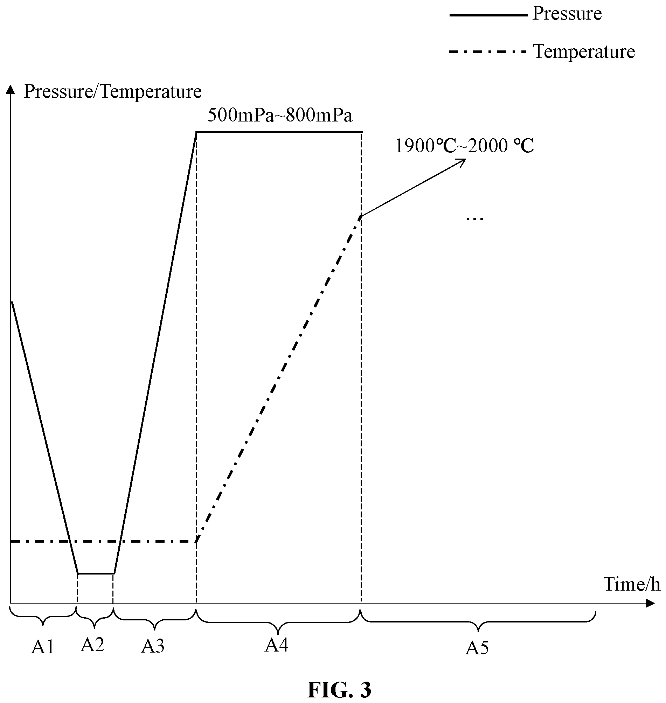

As shown in FIG. 3, the A3 period and the A4 period correspond to the preheating stage, and the A5 period corresponds to the growth control stage. During the A3 period, gas may be introduced into the growth chamber, and the amount of gas introduced into the growth chamber is controlled until the chamber pressure reaches the target pressure range of the preheating stage (e.g., 500 mbar to 800 mbar). During the A4 period, the chamber pressure is maintained within the target pressure range of the preheating stage, and simultaneously, the heating treatment is performed on the growth chamber until the chamber temperature reaches the target temperature range of the preheating stage (e.g., 1900 °C to 2000 °C), and the process may then enter the A5 period. A temperature change rate of the A4 period may be from 5 °C/min to 8 °C/min.

In some embodiments of the present disclosure, first adjusting the pressure and the temperature in the growth chamber to a certain target range during a pretreatment stage may facilitate accelerating entry into the growth control stage for crystal growth.

In some embodiments, a pretreatment may also be performed on the growth chamber before the preheating stage. FIG. 3 is a schematic diagram illustrating an exemplary process curve for a method for crystal growth according to some embodiments of the present disclosure. The pretreatment may include processing operations such as vacuumizing, leak detection and pressure holding, or the like. The solid line in FIG. 3 may indicate a variation of the pressure in the growth chamber, and the dashed line may indicate a variation of the temperature in the growth chamber.

In some embodiments, as shown in FIG. 3, within the A1 period, a vacuumizing treatment may be performed on the growth chamber until the pressure of the growth chamber reaches 10⁻³ Pa to 10⁻⁶ Pa, and the duration of the vacuumizing treatment may be from 3 h to 5 h. After the vacuumizing is completed, within the A2 period, leak detection and pressure holding are performed on the growth chamber, and the duration of the pressure holding may be from 1 h to 2 h. The A1 period and the A2 period correspond to the pretreatment stage. After the pressure holding is completed, within the A3 period, an inert gas (e.g., helium or argon) may be charged into the growth chamber until the pressure in the growth chamber reaches the target pressure range of the preheating stage, and then entering the A4 period. The A3 period and the A4 period correspond to the preheating stage. In some other embodiments, the A3 period may also be regarded as a part of the pretreatment stage.

It should be noted that, the process pressure employed by the existing known PVT method is often several thousand pascals (e.g., 1000 Pa to 2000 Pa). Growing silicon carbide crystals under high pressure conditions may lead to the formation of a large number of dislocations and micropipes. The main principle of defect formation is that vapor phase transport slows down under high pressure, and the width of the growth steps inside the crystal becomes larger, thereby causing a large number of growth step coalescences and carbon inclusions to deposit on the growth steps, consequently forming a large number of dislocations and micropipes. Meanwhile, under high pressure conditions, the crystal growth rate is slow, the crystal growth time is long, and the crystal growth yield of the source material is low, which is not conducive to reducing the crystal growth cost.

In some embodiments of the present disclosure, the low pressure process may be adopted during the growth control stage. Compared to a high pressure process, a low pressure process facilitates accelerating vapor phase transport during the crystal growth process, and makes the width and height of the steps more uniform. This may effectively avoid the coalescence of the steps and the deposition of carbon inclusions on the steps during the crystal growth process.

In some embodiments, the growth control stage may include a control process of first reducing the chamber pressure, maintaining the pressure after reduction for a period of time for crystal growth, and then raising the temperature to the target temperature range. The growth control stage may subsequently be referred to as a first type of control stage.

In some embodiments, when the growth control stage is the first type of control stage, the target pressure range of the growth control stage is 0 mbar to 6 mbar, and the target temperature range of the growth control stage is 2200 °C to 2300 °C.

In some embodiments, the target pressure range of the first type of control stage may also be one of 0 mbar to 5 mbar, 0 mbar to 4 mbar, 0 mbar to 3 mbar, 0 mbar to 2 mbar, 0 mbar to 1 mbar, 1 mbar to 6 mbar, 1 mbar to 5 mbar, 1 mbar to 4 mbar, 1 mbar to 3 mbar, 1 mbar to 2 mbar, 2 mbar to 6 mbar, 2 mbar to 5 mbar, 2 mbar to 4 mbar, 2 mbar to 3 mbar, 3 mbar to 6 mbar, 3 mbar to 5 mbar, 3 mbar to 4 mbar, 4 mbar to 6 mbar, or 4 mbar to 5 mbar. In some embodiments, the target pressure range of the first type of control stage may also be one of 0 mbar, 0.5 mbar, 1 mbar, 1.5 mbar, 2 mbar, 2.5 mbar, 3 mbar, 3.5 mbar, 4 mbar, 4.5 mbar, 5 mbar, 5.5 mbar, or 6 mbar.

In some embodiments, the target temperature range of the first type of control stage may also be one of 2200 °C to 2280 °C, 2200 °C to 2260 °C, 2200 °C to 2240 °C, 2200 °C to 2220 °C, 2220 °C to 2300 °C, 2220 °C to 2280 °C, 2220 °C to 2260 °C, 2220 °C to 2240 °C, 2240 °C to 2300 °C, 2240 °C to 2280 °C, 2240 °C to 2260 °C, 2260 °C to 2300 °C, 2260 °C to 2280 °C, or 2280 °C to 2300 °C. In some embodiments, the target temperature range of the first type of control stage may also be one of 2200 °C, 2100 °C, 2220 °C, 2230 °C, 2240 °C, 2250 °C, 2260 °C, 2270 °C, 2280 °C, 2290 °C, or 2300 °C.

In some embodiments, when the growth control stage is the first type of control stage, controlling the growth process of the crystal based on the stage control parameter comprises: when the chamber temperature of the growth chamber reaches the target temperature range of the preheating stage, extracting the gas from the growth chamber within a first predetermined time so that the chamber pressure reaches the target pressure range of the growth control stage (i.e., the target pressure range of the first type of control stage); maintaining the chamber pressure within the target pressure range of the growth control stage (i.e., the target pressure range of the first type of control stage), and performing the heating treatment after a second predetermined time so that the chamber temperature of the growth chamber reaches the target temperature range of the growth control stage (i.e., the target temperature range of the first type of control stage). The gas may be extracted from the growth chamber by using a mechanical pump.

The first predetermined time refers to the duration for reducing the pressure and causing the chamber pressure to reach the target pressure range of the growth control stage. In some embodiments, the first predetermined time may be from 1 h to 4 h. In some embodiments, the first predetermined time may also be one of 1 h to 3.5 h, 1 h to 3 h, 1 h to 2.5 h, 1 h to 2 h, 1 h to 1.5 h, 1.5 h to 4 h, 1.5 h to 3.5 h, 1.5 h to 3 h, 1.5 h to 2.5 h, 1.5 h to 2 h, 2 h to 4 h, 2 h to 3.5 h, 2 h to 3 h, 2 h to 2.5 h, 2.5 h to 4 h, 2.5 h to 3.5 h, 2.5 h to 3 h, 3 h to 4 h, 3 h to 3.5 h, or 3.5 h to 4 h. In some embodiments, the first predetermined time may also be one of 1 h, 1.5 h, 2 h, 2.5 h, 3 h, 3.5 h, or 4 h.

The second predetermined time refers to the duration of continuous stable growth after the pressure reduction reaches the target pressure range of the growth control stage. In some embodiments, the second predetermined time may be from 5 h to 10 h. In some embodiments, the second predetermined time may also be one of 5 h to 9.5 h, 5 h to 9 h, 5 h to 8.5 h, 5 h to 8 h, 5 h to 7.5 h, 5 h to 7 h, 5 h to 6.5 h, 5 h to 6 h, 5.5 h to 10 h, 5.5 h to 9.5 h, 5.5 h to 9 h, 5.5 h to 8.5 h, 5.5 h to 8 h, 5.5 h to 7.5 h, 5.5 h to 7 h, 5.5 h to 6.5 h, 6 h to 10 h, 6 h to 9.5 h, 6 h to 9 h, 6 h to 8.5 h, 6 h to 8 h, 6 h to 7.5 h, 6 h to 7 h, 6.5 h to 10 h, 6.5 h to 9.5 h, 6.5 h to 9 h, 6.5 h to 8.5 h, 6.5 h to 8 h, 6.5 h to 7.5 h, 7 h to 10 h, 7 h to 9.5 h, 7 h to 9 h, 7 h to 8.5 h, 7 h to 8 h, 7 h to 10 h, 7 h to 9.5 h, 7 h to 9 h, 7 h to 8.5 h, 7 h to 8 h, 8 h to 10 h, 8 h to 9.5 h, 8 h to 9 h, or 9 h to 10 h. In some embodiments, the second predetermined time may also be one of 5 h, 5.5 h, 6 h, 6.5 h, 7 h, 7.5 h, 8 h, 9 h, or 10 h.

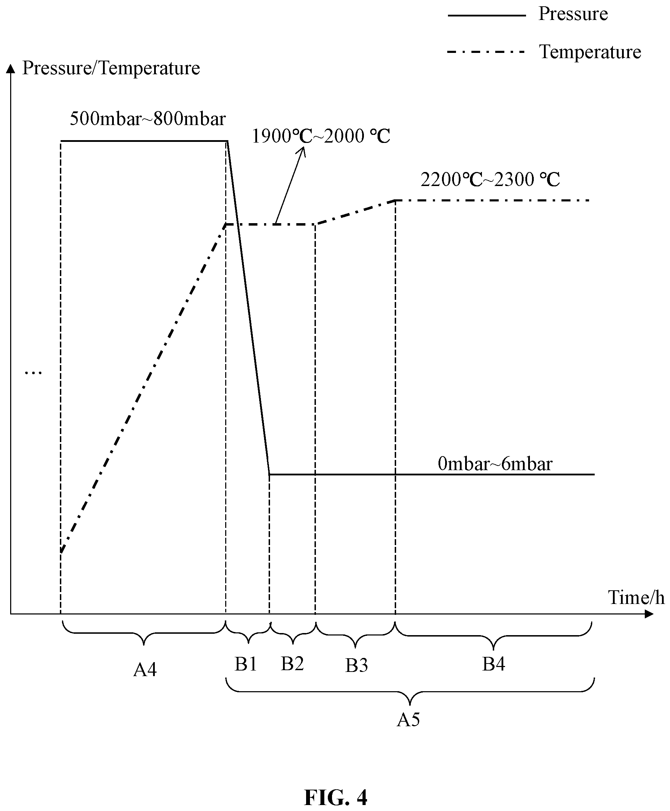

The A5 period in FIG. 4 corresponds to the first type of control stage. The A5 period in FIG. 4 includes four periods: B1; B2; B3; and B4. After the chamber temperature reaches the target temperature range of the preheating stage (e.g., 1900 °C to 2000 °C), the first type of control stage may be entered.

The B1 period is a period for pressure reduction and maintaining the chamber temperature unchanged. During the B1 period, the chamber temperature may be maintained within the target temperature range of the preheating stage (e.g., 1900 °C to 2000 °C), and pressure reduction may be simultaneously performed until the chamber pressure reaches the target pressure range of the first type of control stage (e.g., 0 mbar to 6 mbar), thereafter entering the B2 period. The length of the B1 period refers to the first predetermined time. A pressure reduction process may be achieved by extracting the gas from the growth chamber.

The B2 period refers to a period for maintaining the pressure unchanged and maintaining the chamber temperature unchanged. During the B2 period, the current chamber pressure (e.g., 0 mbar to 6 mbar) and the current chamber temperature (e.g., 1900 °C to 2000 °C) may be maintained, allowing the crystal to grow stably. After the B2 period, the B3 period is entered, and the heating treatment is performed. The length of the B2 period refers to the second predetermined time.

The B3 period is a period for increasing the temperature and maintaining the pressure unchanged. During the B3 period, the current chamber pressure (e.g., 0 mbar to 6 mbar) may be maintained, and the temperature may be simultaneously increased until the chamber temperature reaches the target temperature range of the first type of control stage (e.g., 2200 °C to 2300 °C), thereafter entering the B4 period. In some embodiments, a temperature increase rate of the B3 period may be from 0.5 °C/min to 2 °C/min.

The B4 period refers to a period for maintaining the pressure after pressure reduction unchanged and maintaining the chamber temperature after temperature increase unchanged. During the B4 period, the current chamber pressure (e.g., 0 mbar to 6 mbar) and the current chamber temperature (e.g., 2200 °C to 2300 °C) may be maintained, allowing the crystal in the growth chamber to continue to grow stably until the crystal growth is completed. After the crystal growth is completed and the crystal is cooled to room temperature, the grown crystal is taken out.

In some embodiments, continuous heating may also be performed during the pressure reduction stage of the B1 stage, thereby causing the chamber temperature to reach the target temperature range of the growth control stage and the chamber pressure to reach the target pressure range of the growth control stage. Thereafter, the stable chamber temperature and the stable chamber pressure may be maintained, thereby allowing stable growth of the crystal.

In embodiments of the present disclosure, compared to a high pressure process, a low pressure process may facilitate faster vapor phase transport during the crystal growth process and more uniform step width and height, thereby allowing for obtaining crystals with a low dislocation density (e.g., Basal Plane Dislocation (BPD), Threading Screw Dislocation (TSD), and Threading Edge Dislocation (TED), or the like) and a low micropipe density. Therefore, by performing crystal growth in a low pressure environment (i.e., when the chamber pressure is from 0 mbar to 6 mbar), crystals with better performance (e.g., a low dislocation density and a low micropipe density) may be obtained, and the crystal growth cost may be lower. In the low pressure process, by increasing the chamber temperature, the growth rate of the crystal can be effectively increased. Additionally, after the pressure reduction, stable growth may first be performed for a period of time, and then heating may be performed, to maintain the stability of the vapor phase transport after the pressure reduction, and to prevent a too rapid temperature increase from causing vapor phase disturbance, thereby causing the formation of polycrystals and phase transitions.

Under a low pressure and high temperature environment, the crystal growth rate is faster. At this time, some disadvantages may exist during the growth process of the crystal. For example, the faster the growth, the faster the evaporation, which may cause relatively more the carbon inclusion issues. To solve the carbon inclusion issues, the bulk raw material and/or preparing the second coating layer on the seed crystal holder, or the like, may be used. More descriptions regarding these aspects may be found in the preceding related descriptions.

In some embodiments, the growth control stage may be further subdivided into a plurality of sub-control stages, to control the chamber temperature and the chamber pressure in stages during the growth control stage, and thereby control the growth process of the crystal.

In some embodiments, the growth control stage may include a control process comprising: first performing the pressure reduction, and after reaching a certain pressure, maintaining an isobaric state and increasing the temperature; after reaching a certain temperature, performing the second pressure reduction, during which the temperature continuously increases; and after the second pressure reduction reaches a certain temperature, performing the second isobaric holding and slowly decreasing the temperature. The growth control stage may subsequently be referred to as a second type of control stage.

In some embodiments, when the growth control stage is the second type of control stage, the growth control stage (i.e., the second type of control stage) may include the first pressure reduction stage, the isobaric heating stage, the second pressure reduction stage, and the isobaric cooling stage.

The first pressure reduction stage is the stage in which the pressure reduction is performed for the first time after entering the second type of control stage. During the first pressure reduction stage, the temperature remains unchanged. In some embodiments, the target pressure range of the first pressure reduction stage is from 10 mbar to 12 mbar, and the pressure change rate of the first pressure reduction stage is from -600 mbar/h to -500 mbar/h.

In some embodiments, the target pressure range of the first pressure reduction stage may also be one of 10 mbar to 12 mbar, 10 mbar to 11.8 mbar, 10 mbar to 11.6 mbar, 10 mbar to 11.4 mbar, 10 mbar to 11.2 mbar, 10 mbar to 11 mbar, 10 mbar to 10.8 mbar, 10 mbar to 10.6 mbar, 10 mbar to 10.4 mbar, 10 mbar to 10.2 mbar, 10.5 mbar to 12 mbar, 10.5 mbar to 11.8 mbar, 10.5 mbar to 11.6 mbar, 10.5 mbar to 11.4 mbar, 10.5 mbar to 11.2 mbar, 10.5 mbar to 11 mbar, 10.5 mbar to 10.8 mbar, 10.5 mbar to 10.6 mbar, 11 mbar to 12 mbar, 11 mbar to 11.8 mbar, 10 mbar to 11.6 mbar, 10 mbar to 11.4 mbar, 10 mbar to 11.2 mbar, 11 mbar to 12 mbar, 11 mbar to 11.8 mbar, 11 mbar to 11.6 mbar, 11 mbar to 11.4 mbar, 11 mbar to 11.2 mbar, or the like. In some embodiments, the target pressure range of the first pressure reduction stage may also be one of 10 mbar, 10.2 mbar, 10.4 mbar, 10.6 mbar, 10.7 mbar, 10.8 mbar, 11 mbar, 11.2 mbar, 11.4 mbar, 11.6 mbar, 11.8 mbar, 12 mbar, or the like.

In some embodiments, the pressure change rate of the first pressure reduction stage may also be one of -580 mbar/h to -500 mbar/h, -560 mbar/h to -500 mbar/h, -540 mbar/h to -500 mbar/h, -520 mbar/h to -500 mbar/h, -600 mbar/h to -520 mbar/h, -580 mbar/h to -520 mbar/h, -560 mbar/h to -520 mbar/h, -540 mbar/h to -520 mbar/h, -600 mbar/h to -540 mbar/h, -580 mbar/h to -540 mbar/h, -560 mbar/h to -540 mbar/h, -600 mbar/h to -560 mbar/h, -580 mbar/h to -560 mbar/h, or the like. In some embodiments, the pressure change rate of the first pressure reduction stage may also be one of -500 mbar/h, -510 mbar/h, -520 mbar/h, -530 mbar/h, -540 mbar/h, -550 mbar/h, -560 mbar/h, -570 mbar/h, -580 mbar/h, -590 mbar/h, -600 mbar/h, or the like.

The isobaric heating stage is the stage in which the pressure is maintained unchanged and heating is performed. In some embodiments, the target pressure range of the isobaric heating stage is from 10 mbar to 12 mbar, the target temperature range of the isobaric heating stage is from 2180°C to 2250°C, and the isobaric time of the isobaric heating stage is from 20 h to 30 h. The isobaric time of the isobaric heating stage is the duration of maintaining the pressure unchanged and performing heating during the isobaric heating stage.

In some embodiments, the target pressure range of the isobaric heating stage may also be one of 10 mbar to 11.5 mbar, 10 mbar to 11 mbar, 10 mbar to 10.5 mbar, 10.5 mbar to 12 mbar, 10.5 mbar to 11.5 mbar, 10.5 mbar to 11 mbar, 11 mbar to 12 mbar, 11 mbar to 11.5 mbar, 11.5 mbar to 12 mbar, or the like. In some embodiments, the target pressure range of the isobaric heating stage may also be one of 10 mbar, 10.2 mbar, 10.4 mbar, 10.6 mbar, 10.7 mbar, 10.8 mbar, 11 mbar, 11.2 mbar, 11.4 mbar, 11.6 mbar, 11.8 mbar, 12 mbar, or the like.

In some embodiments, the target temperature range of the isobaric heating stage may also be one of 2190°C to 2250°C, 2200°C to 2250°C, 2210°C to 2250°C, 2220°C to 2250°C, 2180°C to 2240°C, 2190°C to 2240°C, 2200°C to 2240°C, 2210°C to 2240°C, 2220°C to 2240°C, 2180°C to 2230°C, 2190°C to 2230°C, 2200°C to 2230°C, 2180°C to 2220°C, 2190°C to 2220°C, 2200°C to 2220°C, 2180°C to 2210°C, 2190°C to 2210°C, 2180°C to 2210°C, 2190°C to 2210°C, 2180°C to 2200°C, or the like. In some embodiments, the target temperature range of the isobaric heating stage may also be one of 2180°C, 2190°C, 2200°C, 2210°C, 2220°C, 2230°C, 2240°C, 2250°C, or the like.

In some embodiments, the isobaric time of the isobaric heating stage may also be one of 20 h to 28 h, 20 h to 26 h, 20 h to 24 h, 20 h to 22 h, 22 h to 30 h, 22 h to 28 h, 22 h to 26 h, 22 h to 24 h, 24 h to 30 h, 24 h to 28 h, 24 h to 26 h, 26 h to 30 h, 26 h to 28 h, 28 h to 30 h, or the like. In some embodiments, the isobaric time of the isobaric heating stage may also be one of 20 h, 21 h, 22 h, 23 h, 24 h, 25 h, 26 h, 27 h, 28 h, 29 h, 30 h, or the like.

The second pressure reduction stage is the stage in which the pressure reduction is performed for the second time after entering the second type of control stage. During the second pressure reduction stage, the temperature continuously increases. In some embodiments, the target pressure range of the second pressure reduction stage is from 2 mbar to 6 mbar, the pressure change rate of the second pressure reduction stage is -1 mbar/h, and the temperature change rate of the second pressure reduction stage is from +2°C/h to +4°C/h.

In some embodiments, the target pressure range of the second pressure reduction stage may also be one of 2 mbar to 5 mbar, 2 mbar to 3 mbar, 2.5 mbar to 6 mbar, 2.5 mbar to 5 mbar, 2.5 mbar to 4 mbar, 2.5 mbar to 3 mbar, 3 mbar to 6 mbar, 3 mbar to 5 mbar, 3 mbar to 4 mbar, 3.5 mbar to 6 mbar, 3.5 mbar to 5 mbar, 3.5 mbar to 4 mbar, 4 mbar to 6 mbar, 4 mbar to 5 mbar, 4.5 mbar to 6 mbar, 4.5 mbar to 5 mbar, 5 mbar to 6 mbar, or the like. In some embodiments, the target pressure range of the second pressure reduction stage may also be one of 2 mbar, 2.5 mbar, 3 mbar, 3.5 mbar, 4 mbar, 4.5 mbar, 5 mbar, 5.5 mbar, 6 mbar, or the like.

In some embodiments, the pressure change rate of the second pressure reduction stage may also be one of -0.8 mbar/h, -0.6 mbar/h, -0.4 mbar/h, -1.2 mbar/h, - 1.4 mbar/h, -1.6 mbar/h, or the like.

In some embodiments, the temperature change rate of the second pressure reduction stage may also be one of +2°C/h to +3.5°C/h, +2°C/h to +3°C/h, +2°C/h to +2.5°C/h, +2.5°C/h to +4°C/h, +2.5°C/h to +3.5°C/h, +2.5°C/h to +3°C/h, +3°C/h to +4°C/h, +3°C/h to +3.5°C/h, +3.5°C/h to +4°C/h, or the like. In some embodiments, the temperature change rate of the second pressure reduction stage may also be one of +2°C/h, +2.5°C/h, +3°C/h, +3.5°C/h, +4°C/h, or the like.

The isobaric cooling stage is the stage in which the pressure is maintained unchanged and cooling is performed. In some embodiments, the target pressure range of the isobaric cooling stage is from 2 mbar to 6 mbar, the temperature change rate of the isobaric cooling stage is from -2°C/h to -1°C/h, and the isobaric time of the isobaric cooling stage is from 40 h to 50 h.

In some embodiments, the target pressure range of the isobaric cooling stage may also be one of 2 mbar to 5 mbar, 2 mbar to 3 mbar, 2.5 mbar to 6 mbar, 2.5 mbar to 5 mbar, 2.5 mbar to 4 mbar, 2.5 mbar to 3 mbar, 3 mbar to 6 mbar, 3 mbar to 5 mbar, 3 mbar to 4 mbar, 3.5 mbar to 6 mbar, 3.5 mbar to 5 mbar, 3.5 mbar to 4 mbar, 4 mbar to 6 mbar, 4 mbar to 5 mbar, 4.5 mbar to 6 mbar, 4.5 mbar to 5 mbar, 5 mbar to 6 mbar, or the like. The target pressure range of the isobaric cooling stage is the same as the target pressure range of the second pressure reduction stage. In some embodiments, the target pressure range of the isobaric cooling stage may also be one of 2 mbar, 2.5 mbar, 3 mbar, 3.5 mbar, 4 mbar, 4.5 mbar, 5 mbar, 5.5 mbar, 6 mbar, or the like.

In some embodiments, the temperature change rate of the isobaric cooling stage may also be one of -1.8°C/h to -1°C/h, -1.6°C/h to -1°C/h, -1.4°C/h to -1°C/h, -2°C/h to - 1.2°C/h, -1.8°C/h to -1.2°C/h, -1.6°C/h to -1.2°C/h, -1.4°C/h to -1.2°C/h, -2°C/h to -1.4°C/h, -1.8°C/h to -1.4°C/h, -1.6°C/h to -1.4°C/h, or the like. In some embodiments, the temperature change rate of the isobaric cooling stage may also be one of -1°C/h, -1.2°C/h, -1.4°C/h, -1.6°C/h, -1.8°C/h, -2°C/h, or the like.

In some embodiments, the isobaric time of the isobaric cooling stage may also be one of 40 h to 48 h, 40 h to 46 h, 40 h to 44 h, 40 h to 42 h, 42 h to 50 h, 42 h to 48 h, 42 h to 46 h, 42 h to 44 h, 44 h to 50 h, 44 h to 48 h, 44 h to 46 h, 46 h to 50 h, 46 h to 48 h, 48 h to 50 h, or the like. In some embodiments, the isobaric time of the isobaric cooling stage may also be one of 40 h, 41 h, 42 h, 43 h, 44 h, 45 h, 46 h, 47 h, 48 h, 49 h, 50 h, or the like. The isobaric time of the isobaric cooling stage is the duration of maintaining the pressure unchanged and performing cooling during the isobaric cooling stage.

In some embodiments, when the growth control stage is the second type of control stage, controlling the growth process of the crystal based on the stage control parameter comprises: when the chamber temperature of the growth chamber reaches the target temperature range of the preheating stage, extracting the gas from the growth chamber at the pressure change rate of the first pressure reduction stage so that the chamber pressure of the growth chamber reaches the target pressure range of the first pressure reduction stage before entering the isobaric heating stage; during the isobaric time of the isobaric heating stage, maintaining the chamber pressure within the target pressure range of the isobaric heating stage, and simultaneously performing the heating treatment so that the chamber temperature of the growth chamber reaches the target temperature range of the isobaric heating stage; when the chamber temperature of the growth chamber reaches the target temperature range of the isobaric heating stage, extracting the gas from the growth chamber at the pressure change rate of the second pressure reduction stage, and performing the heating treatment at the temperature change rate of the second pressure reduction stage, so that the chamber pressure reaches the target pressure range of the second pressure reduction stage before entering the isobaric cooling stage; and during the isobaric time of the isobaric cooling stage, maintaining the chamber pressure within the target pressure range of the isobaric cooling stage, and simultaneously performing the cooling treatment. The mechanical pump may be controlled to extract the gas from the growth chamber. The growth chamber may be subjected to a heating or cooling treatment by adjusting the power of the heater.

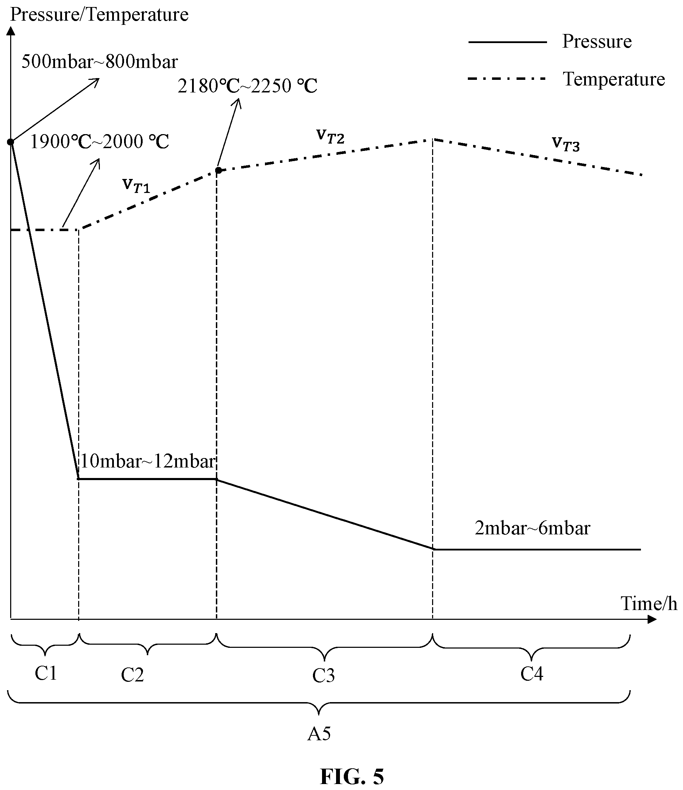

The A5 period in FIG. 5 corresponds to a second type of control stage. The A5 period in FIG. 5 includes C1, C2, C3, and C4 periods.

When the chamber temperature reaches the target temperature range of the preheating stage, the second type of control stage described in the present embodiment may be entered. Because too low a pressure may lead to crystal growth behavior starting at a low temperature, resulting in poor crystal quality, pressure reduction needs to be initiated at a high temperature.

The C1 period corresponds to the first pressure reduction stage. During the first pressure reduction stage, the chamber temperature may be maintained within the target temperature range of the preheating stage (e.g., 1900 °C to 2000 °C). Simultaneously, a first pressure reduction may be initiated, and the pressure may be rapidly reduced at the pressure change rate of the first pressure reduction stage (e.g., -500 mbar/h to -600 mbar/h), until the chamber pressure reaches the target pressure range of the first pressure reduction stage (e.g., 10 mbar to 12 mbar). Because too high a pressure may cause the growth rate of a crystal to be slow and prone to phase change, and the lower the pressure, the faster the growth rate of the crystal, therefore, in an early stage of crystal growth, the crystal growth is unstable and is not suitable for excessively fast growth. During the first pressure reduction stage, due to maintaining the chamber temperature stable, the suction power of the mechanical pump may be changed to control the pressure change rate; when the power is constant, the pressure change rate may be changed by changing the chamber temperature. In some embodiments, because a crystal growth thickness in an early stage is relatively thin, too high a temperature may easily cause sublimation of a seed crystal, and the chamber temperature may be further maintained at 1950 °C to 2000 °C.

When the chamber pressure reaches the target pressure range of the first pressure reduction stage (e.g., 10 mbar to 12 mbar), the isobaric heating stage corresponding to the C2 period may be entered. During the stage, the current chamber pressure may be maintained within the target pressure range of the first pressure reduction stage (e.g., 10 mbar to 12 mbar), and simultaneously a heating treatment may be performed so that the chamber temperature slowly increases to reach the target temperature range of the isobaric heating stage (e.g., 2180 °C to 2250 °C). In some embodiments, the temperature change rate of the isobaric heating stage *v*_{*T*3} is relatively high (e.g., [math_293_1] is higher than [math_293_2] and [math_293_3]), and the crystal growth time of the isobaric heating stage may be 20 h to 30 h. That is, the chamber temperature may be increased from the target temperature range of the preheating stage (e.g., 1900 °C to 2000 °C) to the target temperature range of the isobaric heating stage (e.g., 2180 °C to 2250 °C) within 20 h to 30 h. Too short a crystal growth time of the isobaric heating stage may lead to insufficient crystal growth thickness, and too long a crystal growth time of the isobaric heating stage may lead to excessive crystal growth thickness, a growth surface temperature increase, but a growth pressure mismatch, which may easily lead to a crystal phase change. It should be noted that, when the target temperature range of the isobaric heating stage is 2180 °C to 2250 °C, the temperature range is suitable for 4H crystal growth, and too high or too low a chamber temperature may easily lead to a crystal form transformation.

When the chamber temperature reaches the target temperature range of the isobaric heating stage (e.g., 2180 °C to 2250 °C), a second pressure reduction may be initiated, and the second pressure reduction stage corresponding to the C3 period may be entered. During the stage, a heating treatment may be performed at the temperature change rate of the second pressure reduction stage [math_294_0] (e.g., +2 °C/h to +4 °C/h), and simultaneously the gas may be extracted at the pressure change rate of the second pressure reduction stage (e.g., -1 mbar/h), until the chamber pressure reaches the target pressure range of the second pressure reduction stage (e.g., 2 mbar to 6 mbar). In the second pressure reduction stage, if the pressure change rate is too large and too fast, it may easily lead to disordered crystal growth, poor crystal quality, or even a crystal form transformation. At the same time, the lower the pressure, the faster the gas phase evaporation rate, and the chamber temperature also needs to have a matching change. However, the growth process should be as stable as possible, otherwise, it may easily lead to poor crystal quality or a crystal phase change, therefore, the temperature change rate should also not be excessively fast.

When the chamber pressure reaches the target pressure range of the second pressure reduction stage (e.g., 2 mbar to 6 mbar), the isobaric cooling stage corresponding to the C4 period may be entered. During the stage, the current chamber pressure may be maintained at 2 mbar to 6 mbar, and a cooling treatment may be performed at the temperature change rate of the isobaric cooling stage [math_295_0] (e.g., -1 °C/h to -2 °C/h). The isobaric time of the isobaric cooling stage may be 40 h to 50 h. During the isobaric cooling stage, too low a chamber pressure may cause unstable crystal growth, and carbonized residual material within the target raw material for growth may easily be carried to a growth surface to form carbon inclusions. Therefore, the chamber pressure needs to be stabilized at 2 mbar to 6 mbar. Too short an isobaric time may lead to insufficient crystal growth thickness, and too fast a temperature change rate may lead to a decrease in crystal quality.

In some embodiments, during the entire growth control stage, an inflow rate of gas may be maintained unchanged throughout (e.g., maintained at 100 sccm throughout), and a magnitude of the chamber pressure may be controlled by regulating an extraction rate of the mechanical pump. For example, during an isobaric stage, an amount of gas introduced and an amount of gas extracted, namely the amount of gas extracted by the mechanical pump, may be kept in substantial balance; during a pressure reduction stage, the amount of gas extracted may be controlled to be higher than the amount of gas introduced, thereby reducing the chamber pressure.

In the embodiment of the present disclosure, because a temperature is high in an initial stage of crystal growth, by performing pressure reduction in two stages respectively, it may inhibit sublimation and volatilization of a seed crystal from a back surface when the chamber pressure is high in an early stage, and promote the crystal growth rate by reducing the pressure in a later stage.

In some embodiments, the growth control stage may include a control process for performing staged pressure reduction. The growth control stage may subsequently be referred to as a third type of control stage.

In some embodiments, when the growth control stage is the third type of control stage, a pressure reduction stage of the growth control stage (i.e., the third type of control stage) may be a staged pressure reduction stage.

The staged pressure reduction refers to dividing the pressure reduction into a plurality of pressure reduction stages, and performing the pressure reduction at different pressure change rates in different pressure reduction stages. The plurality of pressure reduction stages may be continuous in time.

In some embodiments, the third type of control stage may include a third pressure reduction stage and a fourth pressure reduction stage. The third pressure reduction stage is a stage in which a pressure reduction is performed for the first time after entering the third type of control stage. The fourth pressure reduction stage is a stage in which a pressure reduction is performed for the second time after entering the third type of control stage. The pressure change rate of the third pressure reduction stage is different from the pressure change rate of the fourth pressure reduction stage. The pressure change rate of the third pressure reduction stage is a first change rate, and the pressure change rate of the fourth pressure reduction stage is a second change rate.

In some embodiments, the first change rate is 6000 mbar/h to 9000 mbar/h. In some embodiments, the first change rate may also be one of 6000 mbar/h to 8500 mbar/h, 6000 mbar/h to 8000 mbar/h, 6000 mbar/h to 7500 mbar/h, 6000 mbar/h to 7000 mbar/h, 6000 mbar/h to 6500 mbar/h, 6500 mbar/h to 9000 mbar/h, 6500 mbar/h to 8500 mbar/h, 6500 mbar/h to 8000 mbar/h, 6500 mbar/h to 7500 mbar/h, 6500 mbar/h to 7000 mbar/h, 7000 mbar/h to 9000 mbar/h, 7000 mbar/h to 8500 mbar/h, 7000 mbar/h to 8000 mbar/h, 7500 mbar/h to 9000 mbar/h, 7500 mbar/h to 8500 mbar/h, 7500 mbar/h to 8000 mbar/h, 8000 mbar/h to 9000 mbar/h, 8000 mbar/h to 8500 mbar/h, or 8500 mbar/h to 9000 mbar/h, or the like. In some embodiments, the first change rate may be one of 6000 mbar/h, 6500 mbar/h, 7000 mbar/h, 7500 mbar/h, 8000 mbar/h, 8500 mbar/h, or 9000 mbar/h, or the like.

In some embodiments, the second change rate is 0 mbar/h to 10 mbar/h. In some embodiments, the second change rate may also be one of 0 mbar/h to 8 mbar/h, 0 mbar/h to 6 mbar/h, 0 mbar/h to 4 mbar/h, 0 mbar/h to 2 mbar/h, 2 mbar/h to 10 mbar/h, 2 mbar/h to 8 mbar/h, 2 mbar/h to 6 mbar/h, 2 mbar/h to 4 mbar/h, 4 mbar/h to 10 mbar/h, 4 mbar/h to 8 mbar/h, 4 mbar/h to 6 mbar/h, 6 mbar/h to 10 mbar/h, 6 mbar/h to 8 mbar/h, or 8 mbar/h to 10 mbar/h, or the like. In some embodiments, the second change rate may be one of 1 mbar/h, 2 mbar/h, 3 mbar/h, 4 mbar/h, 5 mbar/h, 6 mbar/h, 7 mbar/h, 8 mbar/h, 9 mbar/h, or 10 mbar/h, or the like.

In some embodiments, when the growth control stage is the third type of control stage, controlling the growth process of the crystal based on the stage control parameter comprises: when the chamber temperature of the growth chamber reaches the target temperature range of the preheating stage, raising the chamber temperature to a specific temperature range; when the chamber temperature reaches the specific temperature range, maintaining the chamber temperature unchanged, and extracting the gas from the growth chamber at the pressure change rate of the third pressure reduction stage (i.e., the first change rate); when the chamber pressure of the growth chamber is reduced to the pressure threshold, continuing to maintain the chamber temperature unchanged, and extracting the gas from the growth chamber at the pressure change rate of the fourth pressure reduction stage (i.e., the second change rate) until the chamber pressure reaches the target pressure range of the growth control stage (i.e., the target pressure range of the third type of control stage); maintaining the chamber pressure within the target pressure range of the growth control stage (i.e., the target pressure range of the third type of control stage), and simultaneously performing the heating treatment so that the chamber temperature of the growth chamber reaches the target temperature range of the growth control stage (i.e., the target temperature range of the third type of control stage).

The pressure threshold is a pressure value for judging different pressure reduction stages. A pressure reduction stage when the chamber pressure is greater than the pressure threshold is different from a pressure reduction stage when the chamber pressure is not greater than the pressure threshold. In some embodiments, the pressure threshold may be lower than the target pressure range of the preheating stage. In some embodiments, the pressure threshold may be a manually preset value, a system preset value, or the like. For example, the pressure threshold may be 100 mbar, or the like.

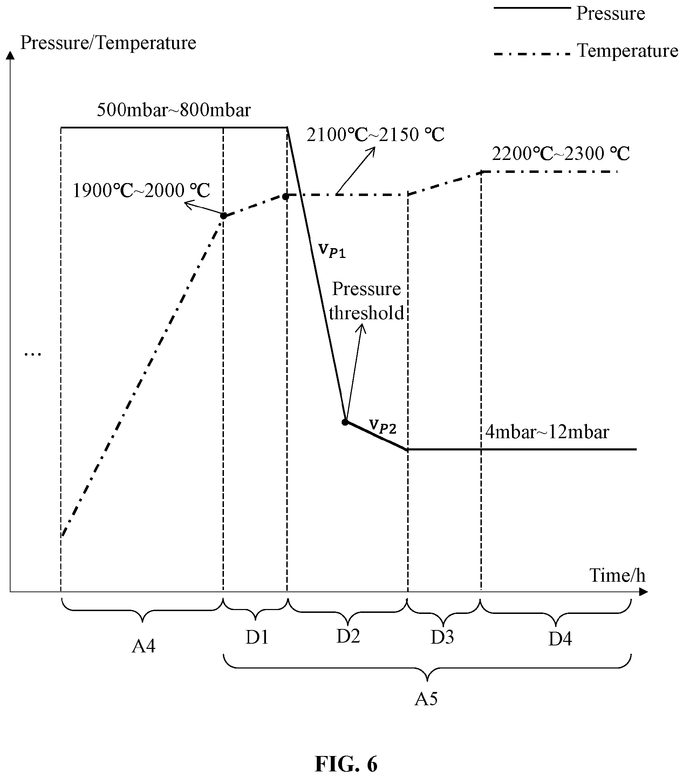

The A5 period in FIG. 6 corresponds to the third type of control stage. The A5 period in FIG. 6 includes D1, D2, D3, and D4 periods. When the chamber temperature reaches the target temperature range of the preheating stage, the method may proceed to a third type of control stage according to the present disclosure.

The D1 period is a first period during which isobaric heating is performed. The D1 period may be referred to as a high-pressure heating stage in the third type of control stage. When the chamber temperature reaches the target temperature range of the preheating stage, a temperature increase rate may be reduced, and the chamber temperature may be increased. During the D1 period, the current chamber pressure may be maintained at the target pressure range of the preheating stage (e.g., 500 mbar to 800 mbar), and simultaneously a heating treatment may be performed so that the chamber temperature reaches a specific temperature range in the third type of control stage (e.g., 2100°C to 2150°C). At this time, the chamber temperature should not be excessively high, otherwise, volatilization of a crystal surface may easily occur.

The D2 stage is a period of staged pressure reduction. The D2 period may be referred to as a staged pressure reduction stage in the third type of control stage. During the D2 stage, the current chamber temperature may be maintained at the specific temperature range in the third type of control stage (e.g., 2100°C to 2150°C), and simultaneously, the chamber pressure may be reduced to the target pressure range of the third type of control stage at different pressure change rates (e.g., 4 mbar to 12 mbar). The staged pressure reduction may include a third pressure reduction stage and a fourth pressure reduction stage. In a third pressure reduction stage, when the chamber pressure is greater than the pressure threshold (e.g., 100 mbar), rapid pressure reduction is performed at a first change rate [math_308_0] (e.g., 6000 mbar/h to 9000 mbar/h). When the chamber pressure is not greater than the pressure threshold, slow pressure reduction is performed at a second change rate [math_308_1] (e.g., 0 mbar/h to 10 mbar/h) until the chamber pressure is reduced to the target pressure range of the third type of control stage (e.g., 4 mbar to 12 mbar). In a high-pressure condition, an excessively slow pressure reduction rate may lead to insufficient vapor phase saturation in an early stage of crystal growth, causing crystal volatilization to be greater than deposition, and thereby deteriorating the crystal quality. Therefore, when the chamber pressure is greater than the pressure threshold, the pressure reduction rate should be relatively high. When the chamber pressure is less than or equal to the pressure threshold, the volatilization of the target raw material for growth will increase, and at this time, the pressure reduction rate should be as slow as possible. When the chamber pressure reaches the target pressure range of the third type of control stage (e.g., 4 mbar to 12 mbar), the method proceeds to a D3 stage.

The D3 stage is a second period for performing isobaric heating. The D3 period may be referred to as a low-pressure heating stage in the third type of control stage. During the D3 stage, the chamber pressure may be stabilized within the target pressure range of the third type of control stage (e.g., 4 mbar to 12 mbar), and simultaneously, the chamber temperature may be slowly increased to the target temperature range of the growth control stage (e.g., 2200°C to 2300°C), and thereafter, the method proceeds to a D4 stage.

The D4 stage is an isobaric and isothermal period. The D4 period may be referred to as an isobaric and isothermal stage in the third type of control stage. During the D4 stage, after the chamber pressure is stabilized within the target pressure range of the third type of control stage (e.g., 4 mbar to 12 mbar) and the chamber temperature is stabilized within the target temperature range of the growth control stage (e.g., 2200°C to 2300°C), a crystal may be grown for a period of time (e.g., 40 to 50 h), thereby completing the growth process. After the crystal completes growth and cools to room temperature, the crystal may be taken out.

In some embodiments, the specific temperature range of the third type of control stage may further be one of 2100°C to 2140°C, 2100°C to 2130°C, 2100°C to 2120°C, 2100°C to 2110°C, 2110°C to 2150°C, 2110°C to 2140°C, 2110°C to 2130°C, 2110°C to 2120°C, 2120°C to 2150°C, 2120°C to 2140°C, 2120°C to 2130°C, 2130°C to 2150°C, 2130°C to 2140°C, or 2140°C to 2150°C, or the like. In some embodiments, the specific temperature range of the third type of control stage may further be one of 2100°C, 2120°C, 2130°C, 2140°C, or 2150°C, or the like.

In some embodiments, the target pressure range of the third type of control stage may further be one of 4 mbar to 11 mbar, 4 mbar to 10 mbar, 4 mbar to 9 mbar, 4 mbar to 8 mbar, 5 mbar to 12 mbar, 5 mbar to 11 mbar, 5 mbar to 10 mbar, 5 mbar to 9 mbar, 5 mbar to 8 mbar, 6 mbar to 12 mbar, 6 mbar to 11 mbar, 6 mbar to 10 mbar, 6 mbar to 9 mbar, 6 mbar to 8 mbar, 7 mbar to 12 mbar, 7 mbar to 11 mbar, 7 mbar to 10 mbar, 7 mbar to 9 mbar, 7 mbar to 8 mbar, 8 mbar to 12 mbar, 8 mbar to 11 mbar, 8 mbar to 10 mbar, 8 mbar to 9 mbar, 9 mbar to 12 mbar, 9 mbar to 11 mbar, 9 mbar to 10 mbar, 10 mbar to 12 mbar, 10 mbar to 11 mbar, or 11 mbar to 12 mbar, or the like. In some embodiments, the target pressure range of the third type of control stage may further be one of 4 mbar, 5 mbar, 6 mbar, 7 mbar, 8 mbar, 9 mbar, 10 mbar, 11 mbar, or 12 mbar, or the like.

In some embodiments, the target temperature range of the growth control stage may further be one of 2200°C to 2280°C, 2200°C to 2260°C, 2200°C to 2240°C, 2220°C to 2300°C, 2220°C to 2280°C, 2220°C to 2260°C, 2220°C to 2240°C, 2240°C to 2300°C, 2240°C to 2280°C, 2240°C to 2260°C, 2260°C to 2300°C, 2260°C to 2280°C, or 2280°C to 2300°C, or the like. In some embodiments, the target temperature range of the growth control stage may further be one of 2200°C, 2100°C, 2220°C, 2230°C, 2240°C, 2250°C, 2260°C, 2270°C, 2280°C, 2290°C, or 2300°C, or the like.

In an early stage of crystal growth, due to instability of pressure and temperature, it is difficult to grow a crystal with relatively good quality in the early stage. In an embodiment of the present disclosure, performing crystal growth in a manner of first heating and then slowly performing the staged pressure reduction in the third type of control stage may control a crystal growth rate in an early stage of crystal growth, allowing the crystal to slowly grow in the early stage, and after growth is stabilized, the growth rate may be increased, thereby obtaining a crystal with relatively good quality. At the same time, it may avoid crystal quality problems caused by the excessively slow pressure reduction rate in the high-pressure condition, and problems of raw material volatilization in a low-pressure condition, thereby obtaining a crystal with relatively good quality.

In some embodiments, the growth control stage may include a control process of first reducing the chamber pressure and then immediately increasing the chamber temperature. The growth control stage may hereinafter be referred to as a fourth type of control stage.

In some embodiments, when the growth control stage is a fourth type of control stage, the target pressure range of the growth control stage (i.e., the fourth type of control stage) may be 0 mbar to 6 mbar, the pressure change rate of the growth control stage (i.e., the fourth type of control stage) is -300 mbar/h to -600 mbar/h, the target temperature range of the growth control stage (i.e., the fourth type of control stage) is 2200°C to 2300°C, and the temperature change rate of the growth control stage (i.e., the fourth type of control stage) is +5°C/h to +10°C/h.

In some embodiments, the target pressure range of the fourth type of control stage may further be one of 0 mbar to 5.5 mbar, 0 mbar to 5 mbar, 0 mbar to 4.5 mbar, 0 mbar to 4 mbar, 0 mbar to 3.5 mbar, 0 mbar to 3 mbar, 0 mbar to 2.5 mbar, 0 mbar to 2 mbar, 1 mbar to 6 mbar, 1 mbar to 5.5 mbar, 1 mbar to 5 mbar, 1 mbar to 4.5 mbar, 1 mbar to 4 mbar, 1 mbar to 3.5 mbar, 1 mbar to 3 mbar, 1 mbar to 2.5 mbar, 1 mbar to 2 mbar, 1.5 mbar to 6 mbar, 1.5 mbar to 5.5 mbar, 1.5 mbar to 5 mbar, 1.5 mbar to 4.5 mbar, 1.5 mbar to 4 mbar, 1.5 mbar to 3.5 mbar, 1.5 mbar to 3 mbar, 1.5 mbar to 2.5 mbar, 1.5 mbar to 2 mbar, 2 mbar to 6 mbar, 2 mbar to 5.5 mbar, 2 mbar to 5 mbar, 2 mbar to 4.5 mbar, 2 mbar to 4 mbar, 2 mbar to 3.5 mbar, 2 mbar to 3 mbar, 2.5 mbar to 6 mbar, 2.5 mbar to 5.5 mbar, 2.5 mbar to 5 mbar, 2.5 mbar to 4.5 mbar, 2.5 mbar to 4 mbar, 2.5 mbar to 3.5 mbar, 2.5 mbar to 3 mbar, 3 mbar to 6 mbar, 3 mbar to 5.5 mbar, 3 mbar to 5 mbar, 3 mbar to 4.5 mbar, 3 mbar to 4 mbar, 3.5 mbar to 6 mbar, 3.5 mbar to 5.5 mbar, 3.5 mbar to 5 mbar, 3.5 mbar to 4.5 mbar, 3.5 mbar to 4 mbar, 4 mbar to 6 mbar, 4 mbar to 5.5 mbar, 4 mbar to 5 mbar, 4.5 mbar to 6 mbar, 4.5 mbar to 5.5 mbar, 4.5 mbar to 5 mbar, 5 mbar to 6 mbar, or 5 mbar to 5.5 mbar, or the like. In some embodiments, the target pressure range of the fourth type of control stage may further be one of 1 mbar, 1.5 mbar, 2 mbar, 2.5 mbar, 3 mbar, 3.5 mbar, 4 mbar, 4 mbar, 5 mbar, 5.5 mbar, or 6 mbar, or the like.

In some embodiments, the pressure change rate of the fourth type of control stage may further be one of -300 mbar/h to -550 mbar/h, -300 mbar/h to -500 mbar/h, - 300 mbar/h to -450 mbar/h, -300 mbar/h to -400 mbar/h, -300 mbar/h to -350 mbar/h, - 350 mbar/h to -600 mbar/h, -350 mbar/h to -550 mbar/h, -350 mbar/h to -500 mbar/h, - 350 mbar/h to -450 mbar/h, -350 mbar/h to -400 mbar/h, -400 mbar/h to -600 mbar/h, - 400 mbar/h to -550 mbar/h, -400 mbar/h to -500 mbar/h, -400 mbar/h to -450 mbar/h, - 450 mbar/h to -600 mbar/h, -450 mbar/h to -550 mbar/h, -450 mbar/h to -500 mbar/h, - 500 mbar/h to -600 mbar/h, -500 mbar/h to -550 mbar/h, or -550 mbar/h to -600 mbar/h, or the like. In some embodiments, the pressure change rate of the fourth type of control stage may further be one of -300 mbar/h, -350 mbar/h, -400 mbar/h, -450 mbar/h, -500 mbar/h, -550 mbar/h, or -600 mbar/h, or the like.

In some embodiments, the target temperature range of the fourth type of control stage may further be one of 2200°C to 2280°C, 2200°C to 2260°C, 2200°C to 2240°C, 2220°C to 2300°C, 2220°C to 2280°C, 2220°C to 2260°C, 2220°C to 2240°C, 2240°C to 2300°C, 2240°C to 2280°C, 2240°C to 2260°C, 2260°C to 2300°C, 2260°C to 2280°C, or 2280°C to 2300°C, or the like. In some embodiments, the target temperature range of the fourth type of control stage may further be one of 2200°C, 2100°C, 2220°C, 2230°C, 2240°C, 2250°C, 2260°C, 2270°C, 2280°C, 2290°C, or 2300°C, or the like.

In some embodiments, the temperature change rate of the fourth type of control stage may further be one of +5°C/h to +9°C/h, +5°C/h to +8°C/h, +5°C/h to +7°C/h, +5°C/h to +6°C/h, +6°C/h to +10°C/h, +6°C/h to +9°C/h, +6°C/h to +8°C/h, +6°C/h to +7°C/h, +7°C/h to +10°C/h, +7°C/h to +9°C/h, +7°C/h to +8°C/h, +8°C/h to +10°C/h, +8°C/h to +9°C/h, or +9°C/h to +10°C/h, or the like. In some embodiments, the temperature change rate of the fourth type of control stage may further be one of +5°C/h, +6°C/h, +7°C/h, +8°C/h, +9°C/h, or +10°C/h, or the like.

In some embodiments, when the growth control stage is a fourth type of control stage, controlling the growth process of the crystal based on the stage control parameter may include: when the chamber temperature of the growth chamber reaches the target temperature range of the preheating stage, extracting gas from the growth chamber at the pressure change rate of the growth control stage (i.e., the pressure change rate of the fourth type of control stage), so that the chamber pressure of the growth chamber reaches the target pressure range of the growth control stage (i.e., the target pressure range of the fourth type of control stage); and when the chamber pressure reaches the target pressure range of the growth control stage (i.e., the target pressure range of the fourth type of control stage), performing the heating treatment at the temperature change rate of the growth control stage (i.e., the temperature change rate of the fourth type of control stage) so that the chamber temperature reaches the target temperature range of the growth control stage (i.e., the target temperature range of the fourth type of control stage).

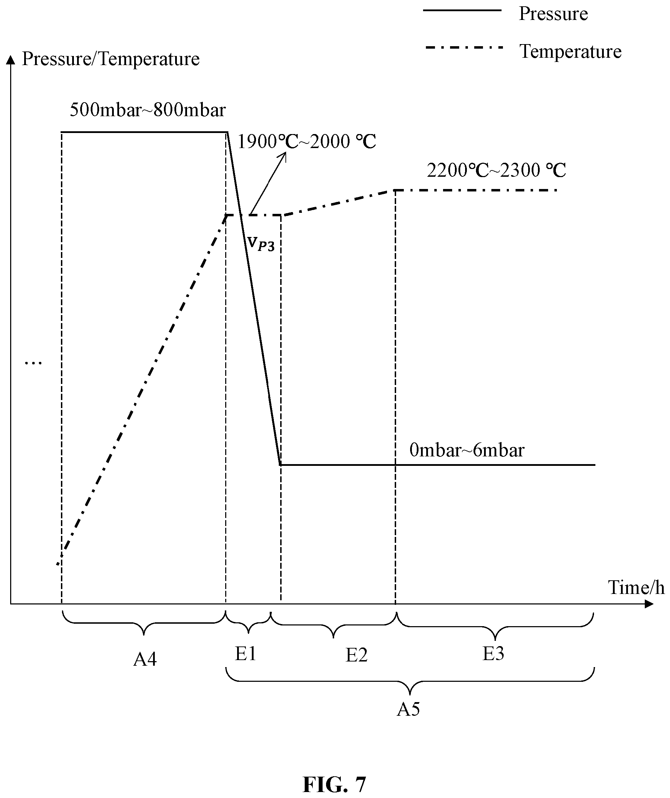

The A5 period in FIG. 7 corresponds to the fourth type of control stage. The A5 period in FIG. 7 includes three periods: E1, E2, and E3. When the chamber temperature reaches the target temperature range of the preheating stage (e.g., 1900°C to 2000°C), the method may proceed to the fourth type of control stage according to the present disclosure.

The E1 period is a period for pressure reduction and maintaining the chamber temperature unchanged. During the E1 period, the chamber temperature may be stabilized within the target temperature range of the preheating stage (e.g., 1900°C to 2000°C), and simultaneously, the chamber pressure may be reduced to the target pressure range of the fourth type of control stage (e.g., 0 mbar to 6 mbar) at the pressure change rate [math_323_0] of the fourth type of control stage (e.g., -300 mbar/h to -600 mbar/h). When the chamber pressure reaches the target pressure range of the fourth type of control stage, the method proceeds to an E2 period.

The E2 period is an isobaric heating period. In the E2 stage, the chamber temperature may be slowly increased to the target temperature range of the fourth category control stage (e.g., 2200°C to 2300°C) at the temperature change rate of the fourth category control stage (e.g., +5°C/h to +10°C/h). When the chamber temperature reaches the target temperature range of the fourth category control stage, the E3 stage is entered.

The E3 stage refers to an isobaric and isothermal stage. In the E3 stage, the chamber pressure is maintained within the target pressure range of the fourth category control stage (e.g., 0 mbar to 6 mbar), and simultaneously, the chamber temperature is maintained within the target temperature range of the fourth category control stage (e.g., 2200°C to 2300°C), and the crystal may grow for a period of time (e.g., 40 to 60 h) before completing the crystal growth process. After the crystal completes growth and cools to room temperature, the crystal may be taken out.

In the initial stage of crystal growth, due to the instability of the pressure and the temperature, it may be difficult to grow a crystal of better quality. In an embodiment of the present disclosure, crystal growth is performed in the fourth category control stage in a manner of first reducing the pressure and then simultaneously slowly increasing the temperature. This may allow for controlling the crystal growth rate in the initial stage of crystal growth, allowing the crystal to grow slowly in the initial stage, and then increasing the growth rate after the growth is stable, thereby obtaining a crystal of better quality.

In some embodiments, the growth control stage may comprise a control process of reducing the chamber pressure while simultaneously increasing the chamber temperature. The growth control stage may subsequently be referred to as the fifth category control stage.

In some embodiments, when the growth control stage is the fifth category control stage, the target pressure range of the growth control stage (i.e., the fifth category control stage) may be from 6 mbar to 12 mbar, the pressure change rate of the growth control stage (i.e., the fifth category control stage) may be from -15 mbar/h to 0 mbar/h, the target temperature range of the growth control stage (i.e., the fifth category control stage) may be from 2200°C to 2300°C, and the temperature change rate of the growth control stage (i.e., the fifth category control stage) may be from +3°C/h to +5°C/h.

In some embodiments, the target pressure range of the fifth category control stage may also be one of 6 mbar to 11 mbar, 6 mbar to 10 mbar, 6 mbar to 9 mbar, 6 mbar to 8 mbar, 6 mbar to 7 mbar, 7 mbar to 12 mbar, 7 mbar to 11 mbar, 7 mbar to 10 mbar, 7 mbar to 9 mbar, 7 mbar to 8 mbar, 8 mbar to 12 mbar, 8 mbar to 11 mbar, 8 mbar to 10 mbar, 8 mbar to 9 mbar, 9 mbar to 12 mbar, 9 mbar to 11 mbar, 9 mbar to 10 mbar, 10 mbar to 12 mbar, 10 mbar to 11 mbar, or 11 mbar to 12 mbar, or the like. In some embodiments, the target pressure range of the fifth category control stage may also be one of 6 mbar, 7 mbar, 8 mbar, 9 mbar, 10 mbar, 11 mbar, or 12 mbar, or the like.

In some embodiments, the pressure change rate of the fifth category control stage may also be one of -15 mbar/h to -2 mbar/h, -15 mbar/h to -4 mbar/h, -15 mbar/h to -6 mbar/h, -15 mbar/h to -8 mbar/h, -15 mbar/h to -10 mbar/h, -15 mbar/h to -12 mbar/h, - 12 mbar/h to 0 mbar/h, -12 mbar/h to -2 mbar/h, -12 mbar/h to -4 mbar/h, -12 mbar/h to - 6 mbar/h, -12 mbar/h to -8 mbar/h, -12 mbar/h to -10 mbar/h, -10 mbar/h to 0 mbar/h, - 10 mbar/h to -2 mbar/h, -10 mbar/h to -4 mbar/h, -10 mbar/h to -6 mbar/h, -10 mbar/h to -8 mbar/h, -8 mbar/h to 0 mbar/h, -8 mbar/h to -2 mbar/h, -8 mbar/h to -4 mbar/h, -8 mbar/h to -6 mbar/h, -6 mbar/h to 0 mbar/h, -6 mbar/h to -2 mbar/h, -6 mbar/h to -4 mbar/h, -4 mbar/h to 0 mbar/h, -4 mbar/h to -2 mbar/h, or -2 mbar/h to 0 mbar/h, or the like. In some embodiments, the pressure change rate of the fifth category control stage may also be one of -15 mbar/h, -14 mbar/h, -13 mbar/h, -12 mbar/h, -10 mbar/h, -8 mbar/h, -6 mbar/h, -4 mbar/h, or -2 mbar/h, or the like.

In some embodiments, the target temperature range of the fifth category control stage may also be one of 2200°C to 2280°C, 2200°C to 2260°C, 2200°C to 2240°C, 2220°C to 2300°C, 2220°C to 2280°C, 2220°C to 2260°C, 2220°C to 2240°C, 2240°C to 2300°C, 2240°C to 2280°C, 2240°C to 2260°C, 2260°C to 2300°C, 2260°C to 2280°C, or 2280°C to 2300°C, or the like. In some embodiments, the target temperature range of the fifth category control stage may also be one of 2200°C, 2100°C, 2220°C, 2230°C, 2240°C, 2250°C, 2260°C, 2270°C, 2280°C, 2290°C, or 2300°C, or the like.

In some embodiments, the temperature change rate of the fifth category control stage may also be one of +3°C/h to +4.5°C/h, +3°C/h to +4°C/h, +3°C/h to +3.5°C/h, +3.5°C/h to +5°C/h, +3.5°C/h to +4.5°C/h, +4°C/h to +4.5°C/h, +4°C/h to +5°C/h, or +4°C/h to +4.5°C/h, or the like. In some embodiments, the temperature change rate of the fifth category control stage may also be one of +3°C/h, +3.2°C/h, +3.5°C/h, +3.7°C/h, +4°C/h, +4.2°C/h, or +4.5°C/h, or the like.

In some embodiments, when the growth control stage is the fifth category control stage, controlling the growth process of the crystal based on the stage control parameter comprises: when the chamber temperature of the growth chamber reaches the target temperature range of the preheating stage, extracting the gas from the growth chamber at the pressure change rate of the growth control stage (i.e., the pressure change rate of the fifth category control stage), and simultaneously performing a heating treatment at the temperature change rate of the growth control stage (i.e., the temperature change rate of the fifth category control stage) so that the chamber temperature reaches the target temperature range of the growth control stage (i.e., the target temperature range of the fifth category control stage).

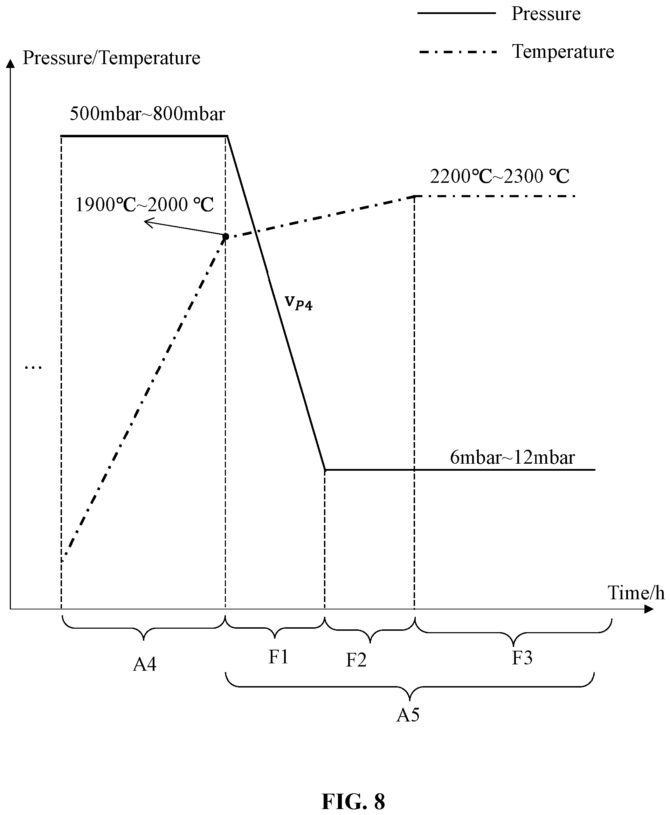

The A5 stage in FIG. 8 corresponds to the fifth category control stage. The A5 stage in FIG. 8 comprises three stages: F1, F2, and F3. When the chamber temperature reaches the target temperature range of the preheating stage (e.g., 1900°C to 2000°C), the fifth category control stage described in the present embodiment may be entered.

The F1 stage refers to a stage of slow pressure reduction and slow temperature increase. In the F1 stage, the chamber pressure may be reduced to the target pressure range of the fifth category control stage (e.g., 6 mbar to 12 mbar) at the pressure change rate of the fifth category control stage (e.g., -15 mbar/h to 0 mbar/h)[math_335_0]. While reducing the pressure, the chamber temperature may be increased at the temperature change rate of the fifth category control stage (e.g., +3°C/h to +5°C/h) until the chamber temperature reaches the target temperature range of the fifth category control stage (e.g., 2200°C to 2300°C). An excessively fast pressure change rate may easily cause the crystal quality to deteriorate.

After the chamber pressure reaches the target pressure range of the fifth category control stage, the chamber temperature may have reached the target temperature range of the fifth category control stage, or may not have reached the target temperature range of the fifth category control stage. If the chamber temperature has not reached the target temperature range of the fifth category control stage, the F2 stage is entered.

The F2 stage refers to the isobaric heating stage. In the F2 stage, the chamber pressure may be maintained within the target pressure range of the growth control stage, and simultaneously, heating may be continued at the temperature change rate of the fifth category control stage (e.g., +3°C/h to +5°C/h) so that the chamber temperature reaches the target temperature range of the fifth category control stage (e.g., 2200°C to 2300°C). During this process, if the temperature change rate is too fast, it may cause a sublimation rate to be greater than a deposition rate, thereby deteriorating the crystal quality. Therefore, the temperature change rate of the fifth category control stage is relatively small.

If the chamber temperature has already reached the target temperature range of the fifth category control stage, then the F3 stage is directly entered.

The F3 stage refers to the isobaric and isothermal stage. In the F3 stage, the chamber pressure is maintained within the target pressure range of the fifth category control stage (e.g., 6 mbar to 12 mbar), and simultaneously, the chamber temperature is maintained within the target temperature range of the fifth category control stage (e.g., 2200°C to 2300°C), and the crystal may grow for a period of time (e.g., 40 to 60 h) before completing the crystal growth process. After the crystal completes growth and cools to room temperature, the crystal may be taken out.

In the initial stage of crystal growth, due to the instability of the pressure and the temperature, it may be difficult to grow a crystal of better quality. In an embodiment of the present disclosure, crystal growth is performed in the fifth category control stage in a manner of simultaneously slowly reducing the pressure and increasing the temperature. This may allow for controlling the crystal growth rate in the initial stage of crystal growth, allowing the crystal to grow slowly in the initial stage, and then increasing the growth rate after the growth is stable, thereby obtaining a crystal of better quality.

FIG. 9 is a flowchart illustrating an exemplary process for preparing a target seed crystal for growth according to some embodiments of the present disclosure. As shown in FIG. 9, a process 900 comprises the following steps.

In 910, a defective seed crystal is selected from initial seed crystals for growth.

The initial seed crystal for growth refers to the seed crystal that has not been processed and screened.

The defective seed crystal refers to an initial seed crystal for growth that does not meet preset growth requirements. The growth requirements refer to requirements to be met by the surface roughness of the seed crystal and the thickness of the seed crystal.

In some embodiments, meeting the growth requirements may include that the thickness of the seed crystal meets a thickness requirement. In some embodiments, an initial seed crystal for growth of which the thickness does not meet the thickness requirement may be determined as a defective seed crystal.

In some embodiments, the thickness requirement may be that the thickness of the seed crystal is greater than 0.15 mm. In some embodiments, the thickness requirement may be that the thickness of the seed crystal is less than 4 mm. In some embodiments, the thickness requirement may be that the thickness of the seed crystal is in a range from 0.15 mm to 4 mm. That is, an initial seed crystal for growth of which the thickness is not in a range from 0.15 mm to 4 mm may be determined as a defective seed crystal. For example, an initial seed crystal for growth with a thickness less than 0.15 mm or greater than 4 mm may be determined as a defective seed crystal.

In some embodiments, meeting a growth requirement may include that a surface roughness Ra of a seed crystal meets a roughness requirement. In some embodiments, an initial seed crystal for growth of which the surface roughness Ra does not meet the roughness requirement may be determined as the defective seed crystal.

In some embodiments, the roughness requirement may be that the surface roughness Ra of the seed crystal is less than 3 nm. In some embodiments, the roughness requirement may be that the surface roughness Ra of the seed crystal is less than 2.9 nm. In some embodiments, the roughness requirement may be that the surface roughness Ra of the seed crystal is less than 2.8 nm. In some embodiments, the roughness requirement may be that the surface roughness Ra of the seed crystal is less than 2.7 nm. In some embodiments, the roughness requirement may be that the surface roughness Ra of the seed crystal is less than 2.6 nm. In some embodiments, the roughness requirement may be that the surface roughness Ra of the seed crystal is less than 2.5 nm.

The surface roughness Ra of the initial seed crystal for growth may be detected by a roughness detection equipment. The roughness detection equipment may be any apparatus capable of detecting a surface roughness of an object (e.g., a roughness measuring instrument, or the like), and is not limited herein. The roughness detection equipment may be any apparatus capable of detecting a surface roughness of an object (e.g., a roughness measuring instrument, or the like), and is not limited herein.

When a seed crystal is too thin, it is not conducive to processing, and cracking may easily occur. When a seed crystal is too thick, it wastes the seed crystal, increases a preparation cost, and may even affect a heat dissipation capability of a back surface of the seed crystal, which is not conducive to stable crystal growth. In an embodiment of the present disclosure, the selecting the defective seed crystal according to the thickness requirement may further process the defective seed crystal to obtain the desired target seed crystal for growth, thereby solving the foregoing problems.

In 920, a first pretreatment is performed on the defective seed crystal to obtain the target seed crystal for growth.

The first pretreatment refers to a process of processing the defective seed crystal to obtain the desired target seed crystal for growth.

In some embodiments, the first pretreatment may include adjusting a thickness of the defective seed crystal. For example, the first pretreatment may include performing processing (e.g., slicing, or the like) on the defective seed crystal of which the thickness exceeds the thickness requirement.

In some embodiments, the first pretreatment may include increasing the thickness of the defective seed crystal of which the thickness does not meet the thickness requirement. In some embodiments, performing the first pretreatment on the defective seed crystal may include: depositing a crystalline layer on a growth surface of the defective seed crystal to adjust the thickness of the defective seed crystal, such that the thickness of the defective seed crystal meets the thickness requirement. For example, if an initial thickness of the defective seed crystal is from 0.1 mm to 3 mm, the thickness of the seed crystal after the first pretreatment may be from 0.15 mm to 4 mm.

The depositing a crystalline layer on a growth surface of the defective seed crystal refers to forming a crystalline material on the growth surface of the defective seed crystal. By depositing a crystalline layer on a growth surface of the defective seed crystal, the thickness of the defective seed crystal may be adjusted.

In some embodiments, the first pretreatment on the defective seed crystal may further include: processing a surface of the defective seed crystal to optimize the surface roughness of the defective seed crystal.

In some embodiments, the surface roughness of the defective seed crystal may be optimized by a polishing treatment. The polishing treatment may be a processing operation of a processing manner that uses mechanical, chemical, or electrochemical methods, or the like, to treat a surface of the seed crystal, thereby reducing the surface roughness of the seed crystal to obtain a bright and smooth surface. If the seed crystal surface is too rough, it may lead to step aggregation, which affects subsequent crystal growth. Optimizing the surface roughness of the defective seed crystal is conducive to high-quality SiC single crystal growth.

There are a plurality of manners for adjusting the thickness of the defective seed crystal. In some embodiments, the thickness of the defective seed crystal may be adjusted by Liquid Phase Epitaxy (LPE) or a Chemical Vapor Deposition (CVD) method.

The LPE method refers to a manner of precipitating a solid phase material from a solution and depositing the solid phase material on a substrate to form a single crystal thin layer.

In some embodiments, a process of depositing a crystalline layer on a growth surface of the defective seed crystal by the LPE method includes: placing the defective seed crystal, the silicon raw material, and the fluxing agent into a graphite crucible; and heating the graphite crucible to melt the silicon raw material and the fluxing agent, wherein a solvent formed by the melted silicon raw material and the melted fluxing agent etches an inner wall of the crucible to obtain a carbon solute; when the carbon solute contacts the defective seed crystal, the carbon solute is deposited on the growth surface of the defective seed crystal to form a silicon carbide single crystal layer.

In some embodiments, the defective seed crystal may be fixed on a seed crystal holder, and the silicon raw material and a small amount of the fluxing agent may be filled into the graphite crucible. The silicon raw material refers to a material comprising a silicon element. In some embodiments, the silicon raw material may include quartz ore. The fluxing agent refers to a substance that assists in melting the silicon raw material. In some embodiments, the fluxing agent may include transition metals or rare earth elements (e.g., Cr, Co, Al, Ce, or the like).

In some embodiments, the graphite crucible may be a vacuum chamber, and an inert gas (e.g., Ar or He) may be introduced into the graphite crucible to maintain a chamber pressure in the graphite crucible.

In some embodiments, an external heater (e.g., an induction heater or a resistance heater) may be used to heat the graphite crucible to above a silicon melting point (e.g., 1600°C to 1900°C), after the silicon raw material and the fluxing agent are fully melted, a solvent is formed and gradually etches an inner wall of the graphite crucible, thereby providing a carbon solute for crystalline layer deposition on the seed crystal. Under action of a temperature gradient and a concentration gradient, after the defective seed crystal contacts a liquid surface of the carbon solute, the dissolved carbon solute migrates to a solid-liquid growth interface and precipitates beneath the defective seed crystal, thereby depositing a high-quality silicon carbide single crystal layer on a growth surface of the defective seed crystal. The solid-liquid growth interface refers to an interface where the defective seed crystal contacts the carbon solute.

Since the temperature is too low, it may cause an increase in a viscosity of a solution or a weak carbon dissolving capability, which is not conducive to crystal growth. However, if the temperature is too high, it will lead to obvious solvent volatilization, and excessive changes in components within the solution will affect crystal growth stability. In some embodiments, an internal temperature of the graphite crucible may reach from 1700°C to 2100°C. In some embodiments, when the internal temperature of the graphite crucible reaches 1700°C, it is raised to 2000°C at a rate of 50°C/h to 100°C/h and maintained for 4 h to 8 h, and then cooled down to 1700°C at a rate of 10°C/h to 50°C/h, thereby completing the growth.

In an embodiment of the present disclosure, preparation by the LPE method may deposit a high-quality SiC single crystal layer on a growth surface of the defective seed crystal, to adjust the thickness of the defective seed crystal.

In some embodiments, depositing a crystalline layer on a growth surface of the defective seed crystal by the CVD method includes: placing the defective seed crystal and the fluxing agent into a graphite crucible; and introducing the reaction gas into the graphite crucible; controlling a temperature and a pressure of the graphite crucible so that the reaction gas decomposes to generate a target gas and deposits the target gas on the growth surface of the defective seed crystal to form a silicon carbide single crystal layer.

The reaction gas refers to a gas that undergoes a chemical reaction with an interior of the graphite crucible. In some embodiments, the reaction gas may include silane (SiH4) and ethylene (C2H4). For example, silane may be transported with the aid of an inert gas (e.g., H2 or He), mixed with ethylene midway, and then introduced together into the graphite crucible.

In some embodiments, the graphite crucible may be heated using an external heater (e.g., an induction heater or a resistance heater), thereby causing the temperature inside the graphite crucible to reach 2100°C to 2300°C. In a high temperature environment, the reaction gas decomposes, generating SiC and depositing on the growth surface of the defective seed crystal. SiC continuously grows along the growth surface of the defective seed crystal, thereby forming the silicon carbide single crystal layer. In some embodiments, the growth pressure of SiC may be 250 mbar to 800 mbar, and a growth rate may be 0.3 mm/h to 1.5 mm/h. That is, the pressure inside the graphite crucible may be controlled to reach 250 mbar to 800 mbar, to facilitate the formation of the silicon carbide single crystal layer. When the reaction occurs inside the graphite crucible, exhaust gas generated during the reaction may be processed and discharged by a matching apparatus (e.g., a mechanical pump).

In an embodiment of the present disclosure, preparing the first coating layer by the CVD method may also deposit the high-quality SiC single crystal layer on the growth surface of the defective seed crystal, to adjust the thickness of the defective seed crystal.

In some embodiments, before depositing the crystalline layer on the growth surface of the defective seed crystal, a first coating layer may be set on a back surface of the defective seed crystal. More descriptions regarding the first coating layer may be found elsewhere in the present disclosure (e.g., FIG. 2 and related descriptions thereof).

In an embodiment of the present disclosure, before depositing the crystalline layer on the growth surface of the defective seed crystal, by setting the first coating layer on the back surface of the defective seed crystal, the first coating layer may be utilized to protect the back surface of the defective seed crystal, preventing sublimation from occurring on the back surface of the defective seed crystal during the formation of the first coating layer, thereby inhibiting the generation of defects such as thermal decomposition pits and hexagonal voids caused by the decomposition and sublimation of the back surface of the defective seed crystal.

FIG. 10 is a flowchart illustrating an exemplary process for preparing raw material for crystal growth according to some embodiments of the present disclosure. As shown in FIG. 10, flow 1000 includes the following steps.

In 1010, an initial powder is obtained based on a first raw material and a second raw material.

The first raw material and the second raw material may be raw materials configured to prepare the target raw material for growth. The first raw material and the second raw material may be powdered raw materials.

The first raw material and the second raw material respectively provide required elements for crystal growth. The first raw material and the second raw material are of different types.

The initial powder refers to the powder obtained after processing the first raw material and the second raw material. For example, the first raw material and the second raw material may be mixed according to a certain ratio and synthesized to obtain the initial powder.

In some embodiments, the first raw material is a carbon raw material, the second raw material is the silicon raw material, and the initial powder is a silicon carbide powder. In some embodiments, the first raw material may be carbon powder with a purity of 99.9999%. In some embodiments, the second raw material may be silicon powder with a purity of 99.999999%.

In some embodiments, obtaining the initial powder based on the first raw material and the second raw material may include: mixing the first raw material and the second raw material according to a preset ratio to obtain mixed raw materials; performing ball milling on the mixed raw materials, and placing the ball-milled mixed raw materials into a crucible; after placing the crucible into the growth chamber, performing at least one treatment of vacuumizing, pressure holding, and furnace washing on the growth chamber, and then synthesizing a plurality of raw materials by increasing temperature to obtain the initial powder and taking the initial powder out.

The mixed raw materials refer to the raw materials obtained after mixing the first raw material and the second raw material according to the preset ratio. In some embodiments, the preset ratio may be a molar ratio of 1:1.1. The preset ratio may also be other ratios, and is not limited thereto.

The ball milling refers to a process of crushing a crushed material by a ball mill. In some embodiments, ball milling may be performed on the mixed raw materials by the ball mill. In some embodiments, the ball mill may include a tube ball mill, a rod ball mill, an ultra-fine laminated mill, a horizontal ball mill, or the like. For example, the ball mill may perform ball milling on the mixed raw materials at a speed of 150 revolutions/min, and a time for the ball milling may be 5 h to 10 h. The ball-milled mixed raw materials may be placed into the graphite crucible. At this time, the graphite crucible may be weighed, and weight data may be recorded. The graphite crucible loaded with the mixed raw materials may be placed into the growth chamber.

The vacuumizing refers to extracting the gas from the growth chamber so that the growth chamber approximates a vacuum. In some embodiments, the growth chamber may be subjected to the vacuumizing treatment until the pressure in the growth chamber is 10⁻⁵ Pa to 10⁻⁶ Pa.

The pressure holding refers to maintaining the pressure in the growth chamber stable. After vacuumizing, performing pressure holding on the growth chamber may detect a sealing condition of the growth chamber. In some embodiments, a pressure holding time of the growth chamber may be 1 h to 2 h.

The furnace washing refers to refilling the growth chamber after vacuumizing with a specific gas. In some embodiments, after the pressure holding is completed, the growth chamber may be filled with an inert gas (e.g., argon, or the like). In some embodiments, a power for filling the inert gas may be 2 kW to 4 kW, and a time for filling the inert gas may be 3 h to 5 h. Controlling the power for filling the inert gas within a range of 2 kW to 4 kW may ensure that the raw materials do not sublimate, and may also discharge existing impurity gas.

After at least one of the above treatments is completed, the growth chamber may be maintained at a positive pressure, and the temperature in the growth chamber may be increased to 2000°C to 2100°C, allowing the ball-milled mixed raw materials to undergo synthesis to obtain the initial powder, namely the silicon carbide powder. A synthesis time may be 25 h to 30 h.

In an embodiment of the present disclosure, the initial powder obtained through mixing, ball milling, and synthesis may be further processed to serve as the target raw material for growth, thereby obtaining the better silicon carbide crystal.

In 1020, the initial powder is placed into the growth chamber for synthesis to obtain an initial raw material for growth.

More descriptions regarding the growth chamber may be found elsewhere in the present disclosure (e.g., FIG. 1 and related descriptions thereof), and will not be described again herein.

The initial raw material for growth refers to the material obtained after further processing the initial powder. In some embodiments, the initial raw material for growth may be a preliminarily obtained bulk raw material.

In some embodiments, the initial powder may be divided into a plurality of portions, and each portion is configured to synthesize a bulk initial raw material for growth. For example, the initial powder may be equally divided into a plurality of portions, each of the portions may be respectively placed into a graphite crucible, and the graphite crucible is placed into a vacuum chamber, thereby synthesizing the bulk initial raw material for growth.

In some embodiments, the placing the initial powder into a growth chamber for synthesis to obtain the initial raw material for growth may comprise: after placing the initial powder into the growth chamber, performing the at least one treatment of vacuumizing, pressure holding, and furnace washing on the growth chamber, and then synthesizing the powder into a bulk material by increasing temperature to obtain the initial raw material for growth and taking the initial raw material for growth out.

More descriptions regarding the vacuumizing, the pressure holding, and the furnace washing may be found elsewhere in the present disclosure (e.g., step 1010 and related descriptions thereof).

In some embodiments, when synthesizing the powder-form initial powder into the bulk initial raw material for growth, the pressure in the growth chamber may be maintained at 0 mbar to 2 mbar, and simultaneously the temperature in the growth chamber may be raised to 2200°C to 2300°C, thereby causing the initial powder in the graphite crucible to be synthesized to obtain the bulk initial raw material for growth. The synthesis time may be 40 h to 60 h. The temperature in the growth chamber may be controlled within a range of 2200°C to 2300°C, which may prevent the graphite crucible from exceeding a temperature resistance limit, and may also prevent a high synthesis cost and a very low material utilization rate when the temperature is too low.

In an embodiment of the present disclosure, the initial raw material for growth obtained through the above processing may be further processed to be the target raw material for growth, thereby obtaining a better silicon carbide crystal.

In 1030, at least one processing operation is performed on the initial raw material for growth to obtain the target raw material for growth.

More descriptions regarding the target raw material for growth may be found elsewhere in the present disclosure (e.g., FIG. 1 and related descriptions thereof).

In some embodiments, the at least one processing operation performed on the initial raw material for growth may comprise at least one of a crushing treatment, a cleaning treatment, and a regrowth treatment. Through the above at least one processing operation, the more suitable target raw material for growth may be obtained.

The crushing treatment refers to crushing the bulk initial raw material for growth into bulk particles having a smaller particle size. In some embodiments, by the crushing treatment, the initial raw material for growth is crushed into a granular raw material for growth having a particle size of 10 mm to 50 mm. In some embodiments, by the crushing treatment, the initial raw material for growth may be crushed into the granular raw material for growth having a particle size of one of 10 mm to 100 mm, 10 mm to 90 mm, 10 mm to 80 mm, 10 mm to 60 mm, 10 mm to 40 mm, 10 mm to 30 mm, or 10 mm to 20 mm. By performing the crushing treatment on the initial raw material for growth, the target raw material for growth may reach a suitable size to facilitate a full reaction during the crystal growth process.

The cleaning treatment refers to a treatment for cleaning the initial raw material for growth. In some embodiments, the cleaning treatment comprises a primary cleaning treatment and a secondary cleaning treatment.

In some embodiments, the primary cleaning treatment comprises: placing the initial raw material for growth into a first solution for soaking and cleaning.

In some embodiments, the secondary cleaning treatment comprises: rinsing the initial raw material for growth after the primary cleaning treatment by using a second solution to obtain the initial raw material for growth with a pH value meeting a set requirement.

In some embodiments, the first solution is a mixed solution of hydrofluoric acid and concentrated hydrochloric acid. In some embodiments, the hydrofluoric acid and the concentrated hydrochloric acid may be mixed according to a volume ratio of 1:1 to obtain the first solution. In some embodiments, the initial raw material for growth or the initial raw material for growth after the crushing treatment may be placed into the first solution for soaking and cleaning, and a time for the primary cleaning treatment may be 30 min to 60 min.

In some embodiments, the second solution may be ultrapure water. The pH value of the initial raw material for growth after the primary cleaning treatment may be adjusted by the second solution. In some embodiments, the set requirement for the pH value of the initial raw material for growth may be 6 to 7. By the second solution, the initial raw material for growth after the primary cleaning treatment may be cleaned to be neutral.

In an embodiment of the present disclosure, contamination may be caused during the crushing treatment of the initial raw material for growth. Therefore, by performing the cleaning treatment on the initial raw material for growth, the cleanliness of the target raw material for growth may be ensured.

In some embodiments, the regrowth treatment comprises: placing the initial raw material for growth into a graphite crucible, adding a catalyst, and then performing growth control; the growth pressure during the growth control is 6 mbar to 12 mbar, and a growth temperature is 2200°C to 2300°C.

In some embodiments, the regrowth treatment may use a PVT method to prepare the bulk target raw material for growth. In some embodiments, the catalyst may be a rare metal compound.

In some embodiments, the growth pressure during the growth control process of the regrowth treatment may also be one of 6 mbar to 11 mbar, 6 mbar to 10 mbar, 6 mbar to 9 mbar, 6 mbar to 8 mbar, 6 mbar to 7 mbar, 7 mbar to 12 mbar, 7 mbar to 11 mbar, 7 mbar to 10 mbar, 7 mbar to 9 mbar, 7 mbar to 8 mbar, 8 mbar to 12 mbar, 8 mbar to 11 mbar, 8 mbar to 10 mbar, 8 mbar to 9 mbar, 9 mbar to 12 mbar, 9 mbar to 11 mbar, 9 mbar to 10 mbar, 10 mbar to 12 mbar, 10 mbar to 11 mbar, or 11 mbar to 12 mbar.

In some embodiments, the growth temperature during the growth control process of the regrowth treatment may also be one of 2200°C to 2280°C, 2200°C to 2260°C, 2200°C to 2240°C, 2220°C to 2300°C, 2220°C to 2280°C, 2220°C to 2260°C, 2220°C to 2240°C, 2240°C to 2300°C, 2240°C to 2280°C, 2240°C to 2260°C, 2260°C to 2300°C, 2260°C to 2280°C, or 2280°C to 2300°C.

In an embodiment of the present disclosure, the target raw material for growth obtained through the above plurality of processing operations may be used to prepare a better silicon carbide crystal.

It should be noted that the descriptions regarding the above processes 200, 900, and 1000 are merely for illustration and description, and do not limit the scope of application of the present disclosure. For those skilled in the art, various modifications and changes may be made to the processes 200, 900, and 1000 under the guidance of the present disclosure. However, these modifications and changes are still within the scope of the present disclosure.

The basic concepts have been described above. Obviously, for those skilled in the art, the detailed disclosure is merely provided as examples and does not constitute limitations on the present disclosure. Although not explicitly stated herein, those skilled in the art may make various modifications, improvements, and amendments to the present disclosure. Such modifications, improvements, and amendments are suggested in the present disclosure, thus such modifications, improvements, and amendments are still within the spirit and scope of the exemplary embodiments of the present disclosure.

Meanwhile, the present disclosure uses particular words to describe the embodiments of the present disclosure. Terms such as 'an embodiment,' 'one embodiment,' and/or 'some embodiments' mean a feature, structure, or characteristic related to at least one embodiment of the present disclosure. Therefore, it should be emphasized and noted that 'one embodiment,' 'an embodiment,' or 'an alternative embodiment' mentioned two or more times in different locations in the present disclosure do not necessarily refer to the same embodiment. Furthermore, certain features, structures, or characteristics in one or more embodiments of the present disclosure may be appropriately combined.

Furthermore, unless explicitly stated in the claims, the order of the processing elements and sequences, the use of numerals and letters, or the use of other designations described in the present disclosure is not intended to limit the order of the processes and manners of the present disclosure. While some embodiments of the present disclosure currently considered useful have been discussed through various examples in the above disclosure, it should be understood that such details are for illustrative purposes only. The appended claims are not limited to the disclosed embodiments. Rather, the claims are intended to cover all modifications and equivalent combinations that fall within the spirit and scope of the embodiments of the present disclosure. For example, although the system components described above may be realized by hardware devices, they may also be realized only through software solutions, such as by installing the described system on an existing server or mobile device.

Similarly, it should be noted that, to simplify the presentation of the present disclosure and to assist in the understanding of one or more embodiments of the present disclosure, in the foregoing descriptions of the embodiments of the present disclosure, a plurality of features are sometimes grouped together in a single embodiment, FIG., or description thereof. However, this method of disclosure does not imply that the subject matter of the present disclosure requires more features than those mentioned in the claims. Indeed, the features of the embodiments are fewer than the entirety of the features of the single embodiment disclosed above.

In some embodiments, numbers describing quantities of components and properties are used. It should be understood that such numbers used in the description of the embodiments are modified by terms such as 'approximately,' 'substantially,' or 'generally' in some examples. Unless otherwise specified, 'approximately', 'approximate', or 'substantially' indicates that the recited numbers allow for a variation of ±20%. Accordingly, in some embodiments, the numerical parameters used in the present disclosure and the claims are approximations that may be varied based on characteristics required by individual embodiments. In some embodiments, the numerical parameters should take into account specified significant digits and employ a generally accepted method of rounding. Although numerical ranges and parameters for confirming the breadth of their scopes are approximations in some embodiments of the present disclosure, in specific embodiments, such numerical values are set as precisely as practicable within a permissible range.

The entirety of each patent, patent application, patent application publication, and other materials, such as articles, books, manuals, publications, or documents, or the like, referenced in the present disclosure is hereby incorporated by reference into the present disclosure. This excludes prosecution history documents inconsistent or in conflict with the content of the present disclosure, and also excludes documents (currently or hereafter attached to the present disclosure) that limit the broadest scope of the claims of the present disclosure. It should be noted that if there is any inconsistency or conflict between the descriptions, definitions, and/or usages of terms in supplementary materials of the present disclosure and the content described in the present disclosure, the descriptions, definitions, and/or usages of terms in the present disclosure shall prevail.

Finally, it should be understood that the embodiments described in the present disclosure are merely for illustrating the principles of the embodiments of the present disclosure. Other variations may also fall within the scope of the present disclosure. Thus, by way of example and not limitation, alternative configurations of the embodiments of the present disclosure may be considered to be consistent with the teachings of the present disclosure. Accordingly, the embodiments of the present disclosure are not limited to the embodiments expressly introduced and described in the present disclosure.

## Claims

1. A method for crystal growth, comprising:
placing a target seed crystal for growth and a target raw material for growth into a growth chamber; and
controlling a growth process of a crystal based on a stage control parameter, wherein the stage control parameter comprises at least one of pressure, temperature, an inflow rate of inert gas, or an opening degree of a control valve.

2. The method according to claim 1, wherein the stage control parameter comprises pressure parameters and/or temperature parameters for a plurality of stages, the plurality of stages comprise a preheating stage and a growth control stage, the pressure parameters comprise at least one of a pressure change rate or a target pressure range, and the temperature parameters comprise at least one of a temperature change rate or a target temperature range.

3. The method according to claim 2, wherein the controlling a growth process of a crystal based on a stage control parameter comprises:
controlling an amount of gas introduced into the growth chamber so that a chamber pressure of the growth chamber reaches the target pressure range of the preheating stage, wherein the target pressure range of the preheating stage is from 500 mbar to 800 mbar; and
maintaining the chamber pressure within the target pressure range of the preheating stage, and performing a heating treatment so that a chamber temperature of the growth chamber reaches the target temperature range of the preheating stage before entering the growth control stage, wherein the target temperature range of the preheating stage is from 1900 °C to 2000 °C.

4. The method according to claim 2, wherein the controlling a growth process of a crystal based on a stage control parameter comprises:
when a chamber temperature of the growth chamber reaches the target temperature range of the preheating stage, extracting gas from the growth chamber within a first predetermined time so that a chamber pressure of the growth chamber reaches the target pressure range of the growth control stage, wherein the target pressure range of the growth control stage is from 0 mbar to 6 mbar; and
maintaining the chamber pressure within the target pressure range of the growth control stage, and performing a heating treatment after a second predetermined time so that the chamber temperature of the growth chamber reaches the target temperature range of the growth control stage, wherein the target temperature range of the growth control stage is from 2200 °C to 2300 °C.

5. The method according to claim 2, wherein the growth control stage comprises a first pressure reduction stage, an isobaric heating stage, a second pressure reduction stage, and an isobaric cooling stage, and the controlling a growth process of a crystal based on a stage control parameter comprises:
when a chamber temperature of the growth chamber reaches the target temperature range of the preheating stage, extracting gas from the growth chamber at the pressure change rate of the first pressure reduction stage so that a chamber pressure of the growth chamber reaches the target pressure range of the first pressure reduction stage before entering the isobaric heating stage; wherein the target pressure range of the first pressure reduction stage is from 10 mbar to 12 mbar, and the pressure change rate of the first pressure reduction stage is from -600 mbar/h to -500 mbar/h;
during an isobaric time of the isobaric heating stage, maintaining the chamber pressure within the target pressure range of the isobaric heating stage, and simultaneously performing a heating treatment so that the chamber temperature of the growth chamber reaches the target temperature range of the isobaric heating stage; wherein the target pressure range of the isobaric heating stage is from 10 mbar to 12 mbar, the target temperature range of the isobaric heating stage is from 2180 °C to 2250 °C, and the isobaric time of the isobaric heating stage is from 20 h to 30 h;
when the chamber temperature of the growth chamber reaches the target temperature range of the isobaric heating stage, extracting gas from the growth chamber at the pressure change rate of the second pressure reduction stage, and performing a heating treatment at the temperature change rate of the second pressure reduction stage, so that the chamber pressure reaches the target pressure range of the second pressure reduction stage before entering the isobaric cooling stage; wherein the target pressure range of the second pressure reduction stage is from 2 mbar to 6 mbar, the pressure change rate of the second pressure reduction stage is -1 mbar/h, and the temperature change rate of the second pressure reduction stage is from +2 °C/h to +4 °C/h; and
during an isobaric time of the isobaric cooling stage, maintaining the chamber pressure within the target pressure range of the isobaric cooling stage, and simultaneously performing a cooling treatment; wherein the target pressure range of the isobaric cooling stage is from 2 mbar to 6 mbar, the temperature change rate of the isobaric cooling stage is from -2 °C/h to -1 °C/h, and the isobaric time of the isobaric cooling stage is from 40 h to 50 h.

6. The method according to claim 2, wherein the growth control stage is a staged pressure reduction stage, and the growth control stage comprises a third pressure reduction stage and a fourth pressure reduction stage; and the controlling a growth process of a crystal based on a stage control parameter further comprises:
when a chamber temperature of the growth chamber reaches the target temperature range of the preheating stage, raising the chamber temperature to a specific temperature range;
when the chamber temperature reaches the specific temperature range, maintaining the chamber temperature unchanged, and extracting gas from the growth chamber at the pressure change rate of the third pressure reduction stage; wherein the pressure change rate of the third pressure reduction stage is from 6000 mbar/h to 9000 mbar/h;
when a chamber pressure of the growth chamber is reduced to a pressure threshold, continuing to maintain the chamber temperature unchanged, and extracting gas from the growth chamber at the pressure change rate of the fourth pressure reduction stage until the chamber pressure reaches the target pressure range of the growth control stage; wherein the pressure change rate of the fourth pressure reduction stage is from 0 mbar/h to 10 mbar/h; and
maintaining the chamber pressure within the target pressure range of the growth control stage, and simultaneously performing a heating treatment so that the chamber temperature reaches the target temperature range of the growth control stage.

7. The method according to claim 2, wherein the controlling a growth process of a crystal based on a stage control parameter comprises:
when a chamber temperature of the growth chamber reaches the target temperature range of the preheating stage, extracting gas from the growth chamber at the pressure change rate of the growth control stage so that a chamber pressure of the growth chamber reaches the target pressure range of the growth control stage; wherein the target temperature range of the growth control stage is from 2200 °C to 2300 °C, and the pressure change rate of the growth control stage is from -10 mbar/min to -5 mbar/min; and
when the chamber pressure reaches the target pressure range of the growth control stage, performing a heating treatment at the temperature change rate of the growth control stage so that the chamber temperature reaches the target temperature range of the growth control stage; wherein the target pressure range of the growth control stage is from 0 mbar to 6 mbar, and the temperature change rate of the growth control stage is from +5 °C/h to +10 °C/h.

8. The method according to claim 2, wherein the controlling a growth process of a crystal based on a stage control parameter comprises:
when a chamber temperature of the growth chamber reaches the target temperature range of the preheating stage, extracting gas from the growth chamber at the pressure change rate of the growth control stage so that a chamber pressure reaches the target pressure range of the growth control stage, and simultaneously performing a heating treatment at the temperature change rate of the growth control stage so that the chamber temperature reaches the target temperature range of the growth control stage;
wherein the target pressure range of the growth control stage is from 6 mbar to 12 mbar, the pressure change rate of the growth control stage is from -15 mbar/h to 0 mbar/h, the target temperature range of the growth control stage is from 2200 °C to 2300 °C, and the temperature change rate of the growth control stage is from +3 °C/h to +5 °C/h.

9. The method according to claim 3, wherein the gas introduced into the growth chamber is an alkyne compound, and the alkyne compound comprises at least one of acetylene or phenylacetylene.

10. The method according to claim 1, wherein a method for preparing the target seed crystal for growth comprises:
selecting a defective seed crystal from initial seed crystals for growth;
performing a first pretreatment on the defective seed crystal to obtain the target seed crystal for growth.

11. The method according to claim 10, wherein selecting the defective seed crystal comprises:
determining the initial seed crystal for growth of which a geometric parameter does not meet a preset parameter requirement as the defective seed crystal; and/or
determining the initial seed crystal for growth of which an existing defect meets a preset condition as the defective seed crystal.

12. The method according to claim 10, wherein performing the first pretreatment on the defective seed crystal comprises:
depositing a crystalline layer on a growth surface of the defective seed crystal to adjust the defective seed crystal.

13. The method according to claim 12, wherein depositing the crystalline layer on the growth surface of the defective seed crystal comprises:
placing the defective seed crystal, a silicon raw material, and a fluxing agent into a graphite crucible;
heating the graphite crucible to melt the silicon raw material and the fluxing agent, wherein a solvent formed by a melted silicon raw material and a melted fluxing agent etches an inner wall of the crucible to obtain a carbon solute; and
when the carbon solute contacts the defective seed crystal, depositing the carbon solute on the growth surface of the defective seed crystal to form a silicon carbide single crystal layer.

14. The method according to claim 12, wherein depositing the crystalline layer on the growth surface of the defective seed crystal comprises:
placing the defective seed crystal and a fluxing agent into a graphite crucible, and introducing a reaction gas into the graphite crucible; and
controlling a temperature and a pressure of the graphite crucible so that the reaction gas decomposes to generate a target gas and deposit the target gas on the growth surface of the defective seed crystal to form a silicon carbide single crystal layer.

15. The method according to claim 12, further comprising:
before depositing the crystalline layer on the growth surface of the defective seed crystal, providing a first coating layer on a back surface of the defective seed crystal, wherein a material type of the first coating layer comprises at least one of tungsten carbide, hafnium carbide, yttrium carbide, or tantalum carbide.

16. The method according to claim 1, further comprising:
before bonding the target seed crystal for growth to a seed crystal holder, providing a first coating layer on a back surface of the target seed crystal for growth, wherein a material type of the first coating layer comprises at least one of tungsten carbide, hafnium carbide, yttrium carbide, or tantalum carbide.

17. The method according to claim 1, wherein the target raw material for growth is a bulk raw material, a particle size of the bulk raw material is from 1 mm to 100 mm, a bulk density of the bulk raw material is from 1.8 g/cm³ to 2.2 g/cm³, a Mohs hardness of the bulk raw material is from 9.0 to 9.5, and a crystal form of the bulk raw material comprises 4H and 6H.

18. The method according to claim 17, wherein a method for preparing the bulk raw material comprises:
obtaining an initial powder based on a first raw material and a second raw material;
placing the initial powder into the growth chamber for synthesis to obtain an initial raw material for growth.
performing at least one processing operation on the initial raw material for growth to obtain the target raw material for growth.

19. The method according to claim 1, wherein placing the target seed crystal for growth into the growth chamber comprises bonding the target seed crystal for growth on a seed crystal holder, the method further comprising:
performing a second pretreatment on the seed crystal holder before placing the target seed crystal for growth and the target raw material for growth into the growth chamber.

20. The method according to claim 19, wherein the seed crystal holder is an annular structure, and the second pretreatment comprises:
preparing a second coating layer on an inner ring surface of the seed crystal holder, the second coating layer having a material hardness greater than Mohs hardness 9, a melting point not less than 3000°C, and excellent chemical stability and corrosion resistance.

21. The method according to claim 20, wherein a material type of the second coating layer comprises tantalum carbide, tungsten carbide, or titanium carbide.

22. The method according to claim 20, wherein an apparatus structure of an apparatus used for preparing the second coating layer comprises an evaporator, a gas pipeline, a heater, a vacuum chamber, a graphite crucible, and the seed crystal holder; the graphite crucible and the seed crystal holder are arranged inside the vacuum chamber, one end of the gas pipeline is connected to the evaporator, and the other end of the gas pipeline is in communication with the vacuum chamber;
the evaporator is configured to evaporate a coating raw material;
the heater is configured to heat the evaporator, the gas pipeline, and the vacuum chamber; and
the gas pipeline is configured to transport gas to the vacuum chamber for a chemical reaction to prepare the second coating layer on the inner ring surface of the seed crystal holder.

23. The method according to claim 21, wherein the preparing a second coating layer on an inner ring surface of the seed crystal holder comprises:
filling an inert gas into the vacuum chamber until a pressure of the vacuum chamber reaches a first pressure range, and simultaneously performing a temperature increasing treatment to cause a temperature of the vacuum chamber to reach a first temperature range; wherein the first pressure range is 100 mbar to 200 mbar, and the first temperature range is 1200°C to 1600°C;
using the heater to increase a temperature of the evaporator to a second temperature range, and performing a preheating treatment on the gas pipeline; wherein the second temperature range is 180°C to 220°C, and a preheating temperature of the gas pipeline is 200°C to 300°C; and
introducing a process gas, the process gas depositing on the inner ring surface of the seed crystal holder to form the second coating layer.

24. A method for preparing raw material for crystal growth, comprising:
obtaining an initial powder based on a first raw material and a second raw material;
placing the initial powder into a growth chamber for synthesis to obtain an initial raw material for growth; and
performing at least one processing operation on the initial raw material for growth to obtain a target raw material for growth.

25. The method according to claim 24, wherein the target raw material for growth is a bulk raw material, a particle size of the bulk raw material is 1 mm to 100 mm, a bulk density of the bulk raw material is 1.8 g/cm2 to 2.2 g/cm2, a Mohs hardness of the bulk raw material is 9.0 to 9.5, and a crystal form of the bulk raw material comprises 4H and 6H.

26. The method according to claim 24, wherein the first raw material is a carbon raw material, the second raw material is a silicon raw material, and the initial powder is a silicon carbide powder; and the obtaining an initial powder based on a first raw material and a second raw material comprises:
mixing the first raw material and the second raw material according to a preset ratio to obtain a mixed raw material;
performing ball milling on the mixed raw material, and placing a ball-milled mixed raw material into a crucible; and
after placing the crucible into the growth chamber, performing at least one of vacuumizing, pressure holding, and furnace washing on the growth chamber, and synthesizing a plurality of raw materials by increasing temperature to obtain the initial powder and taking the initial powder out.

27. The method according to claim 24, wherein the placing the initial powder into a growth chamber for synthesis to obtain an initial raw material for growth comprises:
after placing the initial powder into the growth chamber, performing at least one of vacuumizing, pressure holding, and furnace washing on the growth chamber, and synthesizing the initial powder into a bulk material by increasing temperature to obtain the initial raw material for growth and taking the initial raw material for growth out.

28. The method according to claim 24, wherein the at least one processing operation comprises at least one of a crushing treatment, a cleaning treatment, and a regrowth treatment.

29. The method according to claim 28, wherein the initial raw material for growth is crushed into a granular raw material for growth having a particle size of 10 mm to 50 mm by the crushing treatment.

30. The method according to claim 28, wherein the cleaning treatment comprises a primary cleaning treatment and a secondary cleaning treatment;
the primary cleaning treatment comprises: placing the initial raw material for growth into a first solution for soaking and cleaning, the first solution being a mixed solution of hydrofluoric acid and concentrated hydrochloric acid; and
the secondary cleaning treatment comprises: rinsing the initial raw material for growth after the primary cleaning treatment by using a second solution to obtain the initial raw material for growth with a pH value meeting a set requirement.

31. The method according to claim 28, wherein the regrowth treatment comprises:
placing the initial raw material for growth into a graphite crucible, adding a catalyst, and performing growth control; a growth pressure during the growth control is 6 mbar to 12 mbar, and a growth temperature is 2200°C to 2300°C.
